# EUROPEAN PATENT APPLICATION

(11) **EP 4 797 315 A1**
(43) Date of publication of application: **26.08.2026**
(21) Application number: 24879694.8
(22) Date of filing: 15.10.2024
(51) Int. Cl.: H01L 21/02, F28D 15/02, H05B 3/00

(54) **TEMPERATURE CONTROL DEVICE**

(30) Priority: 18.10.2023 JP 2023179687
(71) Applicant: Kagoshima University, Kagoshima-shi, Kagoshima 890-8580 (JP); Kyocera Corporation, Kyoto-shi, Kyoto 612-8501 (JP)
(72) Inventor: MIZUTA, Kei, Kagoshima-shi, Kagoshima 890-8580 (JP); NABESHIMA, Yutaka, Kyoto-shi, Kyoto 612-8501 (JP); KITAGAWA, Akihiko, Kyoto-shi, Kyoto 612-8501 (JP)
(74) Representative: Viering, Jentschura & Partner mbB Patent- und Rechtsanwälte
(86) International application number: PCT/JP2024/036623
(87) International publication number: WO 2025/084270

(57) **Abstract**

In a temperature control device (1), a heat diffusion plate (10) includes a housing (20) and a working fluid (21). The housing (20) has a sealed internal space (IS), and is made of a material containing one of ceramics, a ceramic composite material, and an inorganic substance except for metal. The working fluid (21) is enclosed in the internal space (IS), and circulates in the internal space (IS) along a surface direction of a first surface (S1) while repeating vaporization by heat reception and condensation by heat radiation. The heat diffusion plate (10) has a smaller Biot number than a solid plate having the same shape, size, and material as the heat diffusion plate (10), and has a larger temperature diffusion coefficient than the solid plate having the same shape, size, and material as the heat diffusion plate (10), in such a way that a heat equalization time from start of heating or heat-absorbing in the heat diffusion plate (10) to completion of temperature equalization on the first surface (S1) is shorter than a heat equalization time for the solid plate having the same shape, size, and material as the heat diffusion plate (10).

## Description

### Technical Field

The present disclosure relates to a temperature control device.

### Background Art

Physical property values of substances and reactions between substances have temperature dependence. Thus, in a processing step of executing some sort of processing on the entire surface of an object spreading in a surface direction, in order to reduce variation in a physical property value of the object to be processed or in a reaction rate in a reaction field where a reaction occurs in the processing, variation in an in-plane temperature of the object needs to be reduced. For example, an assembly is disclosed in which variation in an in-plane temperature of a wafer is reduced by incorporating a thermal phase diffuser into a pedestal for supporting a wafer in a semiconductor manufacturing step (see Patent Literature 1).

### Citation List

### Patent Literature

Patent Literature 1: Unexamined Japanese Patent Application Publication (Translation of PCT Application) No. 2020-526012

### Summary of Invention

### Technical Problem

As described above, in semiconductor processes and various other applications, there is a demand for enabling rapid heat equalization in a controlled object.

The present disclosure has been made in view of the above-described circumstances, and an objective of the present disclosure is to provide a temperature control device capable of rapidly equalizing heat in a controlled object.

### Solution to Problem

In order to achieve the above-described objective, a temperature control device according to a first aspect of the present disclosure includes:
a heat diffusion plate being a member including a facing surface facing a controlled object, the heat diffusion plate being configured to equalize heat in a surface direction of the facing surface; and
a plurality of heat sources to perform heat transfer with the heat diffusion plate, wherein
the heat diffusion plate includes
   a housing having a sealed internal space and being made of a material containing one of ceramics, a ceramic composite material, or an inorganic substance except for metal, and
   a working fluid enclosed in the internal space, the working fluid being configured to circulate in the internal space along the surface direction of the facing surface while repeating vaporization by heat reception and condensation by heat radiation, and
the heat diffusion plate has a smaller Biot number than a solid plate having the same shape, size, and material as the heat diffusion plate, and has a larger temperature diffusion coefficient than the solid plate having the same shape, size, and material as the heat diffusion plate, in such a way that a heat equalization time from start of heating or heat-absorbing in the heat diffusion plate to completion of temperature equalization on the facing surface is shorter than a heat equalization time for the solid plate having the same shape, size, and material as the heat diffusion plate.

The temperature control device may further include:
as the plurality of heat sources, a heating source to heat the heat diffusion plate and a cooling source to cool the heat diffusion plate;
a temperature sensor to detect a temperature distribution of the controlled object; and
a controller to independently control the heating source and the cooling source based on a deviation between a temperature of the controlled object and a target temperature in such a way as to shorten the heat equalization time for the controlled object following the target temperature.

The heating source may be configured as an electrode heater.

The heating source may include one of a high-frequency heater to irradiate a high-frequency electromagnetic wave to heat the working fluid, an induction heater to induce an eddy current in a conductor mounted on the housing to heat the housing, or a light source to irradiate laser light or light to heat the housing, or a combination thereof with an electrode heater.

The heating source may include one of a supply source to supply plasma for heat transfer to the controlled object, a supply source to supply gas for heat transfer to the controlled object, or a supply source to supply liquid for heat transfer to the controlled object, or a combination thereof with an electrode heater.

The cooling source may include one of a flow path structure through which a cooling water flows, a fin, a Peltier element, a cold plate, a cooling element connected to a heat exchanger, a cooling element integrated with a heat exchanger, a supply source to supply gas for heat transfer to the controlled object, or a supply source to supply liquid for heat transfer to the controlled object, or a combination thereof.

At least one of the plurality of heat sources may be mounted on an outer surface parallel to the facing surface in the housing.

At least one of the plurality of heat sources may be mounted in the housing.

A configuration may be provided in which
the housing includes a partition dividing the internal space into two spaces in a direction intersecting the facing surface, and
at least one of the plurality of heat sources is mounted on the partition in the housing.

At least one of the plurality of heat sources may be formed separately from the housing.

The at least one heat source formed separately from the housing may be installed in the housing via a thermal interface material.

At least one of the plurality of heat sources may be disposed on a surface opposite to the facing surface with the internal space interposed therebetween.

At least one of the plurality of heat sources may be disposed between the facing surface and the internal space.

The temperature control device may further include:
as the plurality of heat sources, a first heat source disposed on a surface opposite to the facing surface with the internal space interposed therebetween, and a second heat source disposed between the facing surface and the internal space, wherein
a distance between the first heat source and the internal space is greater than or equal to a distance between the second heat source and the internal space.

The temperature control device may further include:
as the plurality of heat sources, a first heat source disposed on a surface opposite to the facing surface with the internal space interposed therebetween, and a second heat source disposed between the facing surface and the internal space, wherein
a distance between the first heat source and the internal space is less than or equal to a distance between the second heat source and the internal space.

The temperature control device may further include:
a holding mechanism to absorb and hold the controlled object, wherein
the holding mechanism is one of an electrostatic adsorption mechanism to electrostatically adsorb the controlled object, a vacuum absorption mechanism to vacuum-adsorb the controlled object, or a clamp mechanism to hold the controlled object with a clamp.

A configuration may be provided in which
the holding mechanism includes a plurality of pins protruding from the facing surface, and a gap is provided between the controlled object and the facing surface by holding the controlled object with the plurality of pins.

The holding mechanism may include a gas supply mechanism to fill the gap with gas.

The housing may be made of one of ceramics, a ceramic composite material, an inorganic substance except for metal, a composite resin of ceramics and a resin, or a composite resin of an inorganic substance and a resin.

An inner surface of the housing may be made of a material not corroded by the working fluid.

The housing may be in contact with the controlled object via a thermal interface material.

An area of a portion of the plurality of heat sources facing the heat diffusion plate may be equal to or smaller than an area of the facing surface.

The facing surface may have a surface shape curved relative to a plane.

A plurality of the heat diffusion plates may be stacked in a normal direction of the facing surface.

### Advantageous Effects of Invention

The present disclosure enables rapid heat equalization in a controlled object.

### Brief Description of Drawings

FIG. 1 is a side view and a bottom view of a temperature control device according to an embodiment of the present disclosure;
FIG. 2 is a schematic diagram illustrating an internal structure of a heat diffusion plate;
FIG. 3A is a block diagram of a control system in the temperature control device;
FIG. 3B is a graph illustrating a step response in which a temperature of a controlled object follows a target temperature to achieve heat equalization;
FIG. 4A is a graph illustrating a temperature characteristic of a reaction rate;
FIG. 4B is a graph illustrating a temperature characteristic of a physical property value;
FIG. 5 is a schematic diagram illustrating a way of spreading heat energy in a surface direction in the heat diffusion plate;
FIG. 6 is a graph illustrating a dimensionless temperature distribution in a radial direction of the heat diffusion plate;
FIG. 7A is a block diagram illustrating a hardware configuration of an information processing device;
FIG. 7B is a flowchart of design processing by the information processing device;
FIG. 8 is a graph illustrating a temperature characteristic of heat conductivity of the heat diffusion plate;
FIG. 9A is a schematic diagram illustrating a first modified example of the temperature control device;
FIG. 9B is a schematic diagram illustrating a second modified example of the temperature control device;
FIG. 9C is a schematic diagram illustrating a third modified example of the temperature control device;
FIG. 9D is a schematic diagram illustrating a fourth modified example of the temperature control device;
FIG. 9E is a schematic diagram illustrating a fifth modified example of the temperature control device;
FIG. 10A is a schematic diagram illustrating a sixth modified example of the temperature control device;
FIG. 10B is a schematic diagram illustrating a seventh modified example of the temperature control device;
FIG. 10C is a schematic diagram illustrating an eighth modified example of the temperature control device;
FIG. 11A is a schematic diagram illustrating a ninth modified example of the temperature control device;
FIG. 11B is a schematic diagram illustrating a tenth modified example of the temperature control device;
FIG. 11C is a schematic diagram illustrating an eleventh modified example of the temperature control device;
FIG. 11D is a schematic diagram illustrating a twelfth modified example of the temperature control device;
FIG. 12A is a schematic diagram illustrating a configuration of a plasma treatment device;
FIG. 12B is an enlarged view of a portion in FIG. 12A;
FIG. 13A is a schematic diagram illustrating a configuration of a substrate processing device;
FIG. 13B is a schematic diagram illustrating a configuration of a shower head in FIG. 13A;
FIG. 13C is a schematic diagram illustrating a configuration of a substrate holder in FIG. 13A;
FIG. 14A is a schematic diagram illustrating a thirteenth modified example of the temperature control device;
FIG. 14B is a schematic diagram illustrating a fourteenth modified example of the temperature control device;
FIG. 14C is a schematic diagram illustrating a fifteenth modified example of the temperature control device;
FIG. 14D is a schematic diagram illustrating a sixteenth modified example of the temperature control device;
FIG. 15A is a schematic diagram illustrating a seventeenth modified example of the temperature control device; and
FIG. 15B is a schematic diagram illustrating an eighteenth modified example of the temperature control device.

### Description of Embodiments

Hereinafter, an embodiment of the present disclosure is described in detail with reference to the drawings. The same or equivalent parts are denoted by the same reference sign in the drawings.

### Basic Configuration of Temperature Control Device

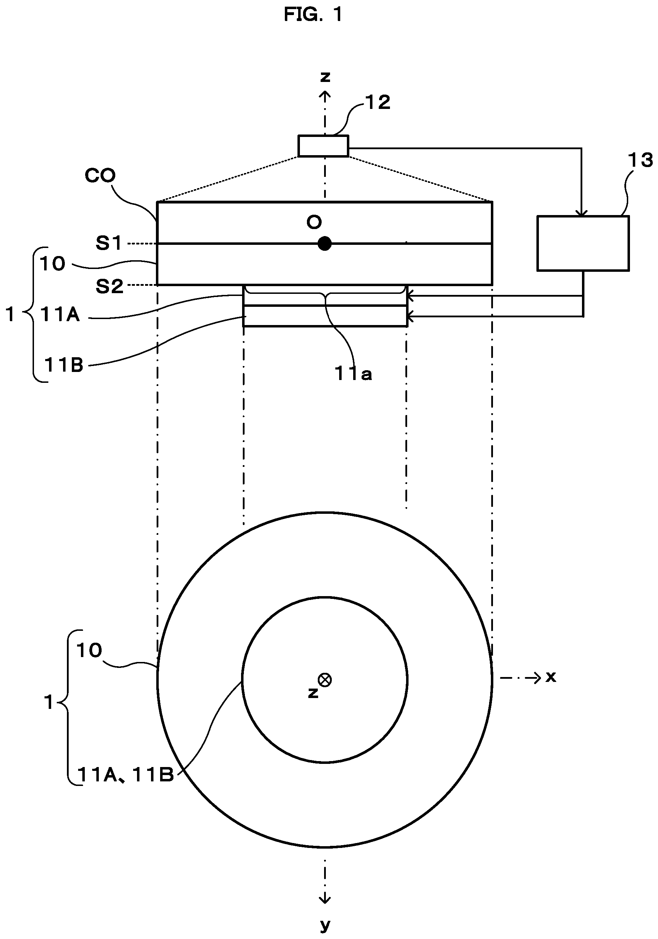

First, a basic configuration of a temperature control device to be designed by a design method according to the present embodiment is described. As illustrated in FIG. 1, a temperature control device 1 controls a temperature of a controlled object CO. The controlled object CO represents, for example, a substance or a space. Examples of a space serving as the controlled object CO include a space serving as a reaction field for a substance. The temperature control device 1 includes a heat diffusion plate 10 and a plurality of heat sources 11A and 11B. The heat diffusion plate 10 and the plurality of heat sources 11A and 11B each have a disk shape in FIG. 1, but are not limited thereto. The same applies to the controlled object CO, and there is no limitation on a shape of the controlled object CO.

The heat diffusion plate 10 includes circular surfaces with a z-axis direction as its normal direction. Among these surfaces, a surface facing a +z direction is defined as a first surface S1. The first surface S1 is a facing surface that faces the controlled object CO. The heat diffusion plate 10 equalizes heat in a surface direction of the first surface S1. A surface facing a -z direction with the z-axis direction as its normal direction is defined as a second surface S2. The heat diffusion plate 10 is a member that includes the first surface S1 and the second surface S2. The first surface S1 and the second surface S2 are main surfaces on the front and back of the heat diffusion plate 10 that are parallel to each other and face in opposite directions. A distance between the first surface S1 and the second surface S2 corresponds to a plate thickness of the heat diffusion plate 10.

The heat diffusion plate 10 and the heat sources 11A and 11B are concentrically disposed about a z-axis together with the controlled object CO. The heat sources 11A and 11B perform heat transfer with the heat diffusion plate 10. In the present embodiment, a radius of the heat diffusion plate 10 is the same as a radius of the control subject CO, and a radius of each of the heat sources 11A and 11B is smaller than the radius of the heat diffusion plate 10.

The heat diffusion plate 10 is disposed on a +z side of the heat source 11A in such a way that the second surface S2 faces the heat source 11A. The heat source 11B faces a surface of the heat source 11A facing the -Z direction. Thus, the heat sources 11A and 11B are stacked on the second surface S2 of the heat diffusion plate. The controlled object CO is disposed on a +z side of the heat diffusion plate 10 in such a way that the first surface S1 faces the heat diffusion plate 10. The heat sources 11A and 11B are thermally bonded to the heat diffusion plate 10 in a circular region 11a (region having the same radius as the heat sources 11A and 11B) on the second surface S2.

As the plurality of heat sources 11A and 11B, heat sources capable of controlling an amount of heat for heating or heat-absorbing in the heat diffusion plate 10 can be used. The heat diffusion plate 10 diffuses heat in the surface direction of the first surface S1. The heat diffusion plate 10 with heat equalized in the surface direction of the first surface S1 by heating or heat-absorbing by the heat sources 11A and 11B performs heating or heat-absorbing in the controlled object CO via the first surface S1.

The heat source 11A is a heating source for heating the heat diffusion plate 10, and the heat source 11B is a cooling source for cooling the heat diffusion plate 10. When the heat source 11A heats the heat diffusion plate 10, heat from the heat source 11A is applied to the heat diffusion plate 10 via the circular region 11a of the second surface S2. The heat diffusion plate 10 diffuses the heat in the surface direction of the first surface S1, that is, in a radial direction with the z-axis direction as its center. The heat diffused in the radial direction is transferred to the controlled object CO. The transferred heat controls the temperature of the controlled object CO to a target temperature.

When the heat source 11B cools the heat diffusion plate 10, heat-absorbing by the heat source 11B reduces a temperature of the heat diffusion plate 10 via the heat source 11A and the circular region 11a of the second surface S2. This reduction in temperature in the region 11a causes a coolant in the heat diffusion plate 10 to move in the radial direction, and uniformly reduces a temperature of the first surface S1. In this manner, the heat diffusion plate 10 uniformly cools the controlled object CO over the entire first surface S1.

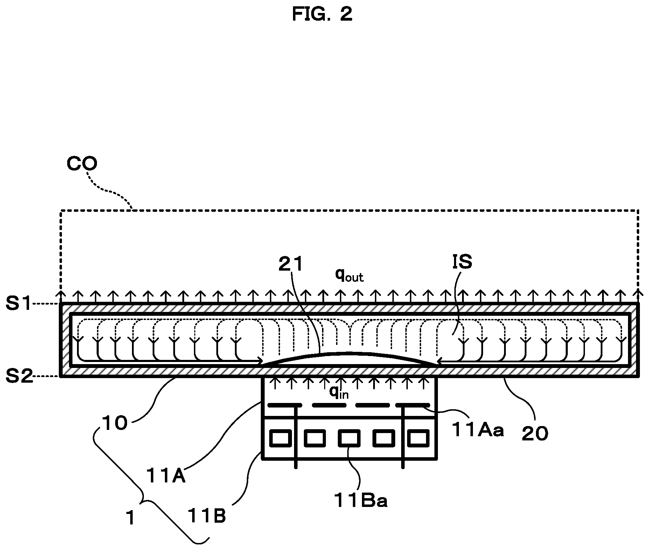

As illustrated in FIG. 2, the heat diffusion plate 10 includes a housing 20 having a sealed internal space IS, and a working fluid 21 as a coolant enclosed in the internal space IS. In the internal space IS, the working fluid 21 in a liquefied state and the working fluid 21 in a vaporized state coexist while maintaining an equilibrium state. The working fluid 21 in the liquefied state is present directly above the heat source 11A. The working fluid 21 is vaporized by heat transferred from the heat source 11A, transfers (radiates) the heat to the housing 20 while moving in the surface direction of the first surface S1 in the internal space IS, and gradually condenses. The condensed working fluid 21 is configured to return to a position directly above the heat source 11A by capillary force of a capillary flow path (not illustrated) formed in the internal space IS. In this manner, the working fluid 21 circulates in the internal space IS along the surface direction of the first surface S1 while repeating vaporization by heat reception and condensation, and diffuses heat in the surface direction of the first surface S1. The working fluid 21 can be, for example, pure water, but may be an organic substance or may be a mixture of an organic substance and water. As the working fluid 21, other coolants may be used in accordance with the required thermal and physical properties. The working fluid 21 not corroding the interior of the housing 20 is preferably used.

The housing 20 is made of a low thermal expansion material. Examples of such a substance include ceramics. The ceramics can be in particular fine ceramics, such as arium titanate, lead zirconate titanate, ferrite, alumina, forsterite, silicon nitride (SN), aluminum nitride (AIN), silicon carbide, Y₂O₃, zirconia, zircon, mullite, steatite, cordierite, diamond as a single crystal material, or sapphire, but are not limited thereto. The ceramics may be fine ceramics. The examples of such a substance also include a ceramic composite material. The ceramic composite material may be silicon-infiltrated reaction-bonded silicon carbide (SiSiC), ceramic matrix composites (CMC), or the like, but is not limited thereto. The examples of such a substance other than the above-described substances include glass, carbon, graphite, and silicon, but are not limited thereto. The material of the housing 20 may be a composite resin containing ceramics or an inorganic substance. In other words, the housing 20 is made of a material containing ceramics or the like, as described later. Ceramics or the like is a material that is resistant to corrosion by liquids. When the working fluid 21 is highly corrosive, ceramics or the like is desirably used as the material of the housing 20. An inner surface of the housing 20 is made of a material that is not corroded by the working fluid 21.

Thermal expansion coefficients of respective substances are indicated in the following table.

**[Table 1]**

| Material | Temperature | Thermal expansion coefficient |
|---|---|---|
| Copper | 20-300°C | 16.8 × 10⁻⁶/K |
| SUS304 | 0-100°C | 17.3 × 10⁻⁶/K |
| A6063 | 20-100°C | 23.4 × 10⁻⁶/K |
| Alumina | 40-400°C | 7.2 × 10⁻⁶/K |
| Silicon nitride | 40-400°C | 2.8 × 10⁻⁶/K |
| Soda-lime glass | RT-350°C | 8.5 × 10⁻⁶/K |
| Quartz (SiO₂) | RT-300°C | 0.5 × 10⁻⁶/K |
| Si | RT-1000°C | 3.9 × 10⁻⁶/K |
| Graphite | RT-450°C | 3.2 × 10⁻⁶/K |
| Si-SiC | RT-1000°C | 4.2 × 10⁻⁶/K |

As a substance used as the material of the housing 20, a substance having a thermal expansion coefficient smaller than that of metal, such as copper, is selected. A configuration in which a substance having a small thermal expansion coefficient is used as the material of the housing 20 can reduce deformation of the heat diffusion plate 10 and a numerical change of an overall heat transfer coefficient h when the controlled object CO or the heat source 11A or 11B generates heat. This facilitates determination of the overall heat transfer coefficient h. In the present embodiment, a substance having a thermal expansion coefficient of 8.0 × 10⁻⁶ [1/K] or less is desirably selected as the material of the housing 20.

The above-described materials, such as ceramics, selected as the material of the housing 20 are known as materials having high rigidity. Therefore, the housing 20 is not warped by heat or aging deterioration and is resistant to deformation. Further, the above-described materials have high chemical stability and are resistant to corrosion even when, for example, the working fluid 21 is highly corrosive to metals. Furthermore, the above-described materials have low swelling properties and have compositions that are insoluble in water. Furthermore, employing the above-described materials allows the housing 20 to be reduced in weight and to have high specific rigidity. Furthermore, ceramics or the like has insulating properties and are suitable for use in portions where insulation is required.

The heat source 11A can be configured as an electrode heater including heat transfer wires 11Aa, as illustrated in FIG. 2. Further, together with the electrode heater or in place of the electrode heater, a component including an element, a device, a module, a circuit substrate, or the like that generates heat by operation may be used as the heat source 11A, or a heat source that transfers heat from outside a reaction chamber in which the heat diffusion plate 10 is installed via a wall (hot wall) may be used. Furthermore, a component in which a heat-accompanied gas, liquid (water or a chemical solution), or the like circulates may be used as the heat source 11A. Furthermore, any one of a high-frequency heater that irradiates high-frequency electromagnetic waves to heat the working fluid 21, an induction heater that induces eddy currents in a conductor mounted on the housing 20 to heat the housing 20, and a light source (for example, a xenon lamp) that irradiates laser light or light to heat the housing 20 may be used as the heat source 11A. The ceramic housing 20 has a high emissivity, and is thus suitable for a configuration in which the light source is used as the heat source 11A. Further, either a plasma supply source that supplies plasma to the controlled object CO or a supply source that supplies a cleaning liquid or a reaction liquid to the controlled object CO may be used as the heat source 11A. As described above, in the temperature control device 1 according to the present embodiment, the type of the heat source 11A is not limited, and various types of the heat source 11A can be employed. When a plurality of heat sources 11A are provided, the above-described heat sources can be used in combination.

In the heat source 11B, a water-cooling flow path structure can be used that includes a cooling water flow path 11Ba through which cooling water flows. Further, the heat source 11B can be any one of a fin, a Peltier element, and a cold plate. Furthermore, as illustrated in FIG. 2, any one of a cooling element connected to a heat exchanger, a cooling element integrated with a heat exchanger, a supply source that supplies gas for heat transfer to the controlled object CO, and a supply source that supplies liquid for heat transfer to the controlled object CO may be employed as the heat source 11B. Furthermore, the heat source 11B may be a combination of the above-described components, for example, a cooling flow path structure provided with a fin. In the temperature control device 1 according to the present embodiment, the type of the heat source 11B is not limited, and various types of the heat source 11B can be employed.

FIG. 1 illustrates the heat diffusion plate 10 in contact with the heat sources 11A and 11B and the controlled object CO. However, as described above, the heat diffusion plate 10 may actually be spaced from the heat sources 11A and 11B and the controlled object CO. For example, the housing 20 of the heat diffusion plate 10 is made of ceramics or the like having high emissivity, and thus can sufficiently transfer heat to the controlled object CO.

### Effect of Configuration of Temperature Control Device 1

The heat sources 11A and 11B and the controlled object CO indirectly face via the heat diffusion plate 10. When the heat sources 11A and 11B and the controlled object CO directly face, there is a difference in a heat transfer rate between a portion in contact with the heat sources 11A and 11B and a portion not in contact therewith. This results in unevenness in a temperature distribution of the controlled object CO.

It is also conceivable that the heat sources 11A and 11B having the same radius as the radius of the controlled object CO are directly connected to the controlled object CO. However, in this case, when the heat source 11A is, for example, an electrode heater, electrical resistance locally changes due to temperature unevenness in the electrode heater, and sufficient temperature smoothness is thus difficult to achieve. When the heat source 11B is, for example, a Peltier module, a plurality of elements including a heat transfer surface smaller than the entire module is disposed on a surface, and each of the elements performs heating or heat-absorbing. However, there is a gap between the elements, and in order to reduce an influence of the gap, a small heat diffusion plate (hereinafter, referred to as a compact heat diffusion plate) is disposed on the heat transfer surface. The compact heat diffusion plate is far smaller than the heat diffusion plate 10. The compact heat diffusion plate is made of copper, and thus has insufficient heat diffusion performance. Thus, unevenness of a heat flux between a portion with the element and a portion without the element cannot be sufficiently reduced. As a result, temperature smoothness sufficient for a permissible value of temperature unevenness is difficult to achieve. As described above, when the heat sources 11A and 11B and the control subject CO are directly connected, it is difficult to equalize the heat transfer rate on the entire surface of the controlled object CO in order to achieve a smooth temperature distribution sufficient for the permissible value of temperature unevenness. In order to reduce the above-described unevenness of the heat transfer rate, the temperature control device 1 has the configuration in which the heat sources 11A and 11B are connected to the controlled object CO via the heat diffusion plate 10.

### Biot Number

Herein, a Biot number Biᵣ in the radial direction (direction along the first surface S1) of the heat diffusion plate 10 is represented by the following equation. ${Bi}_{r} = \frac{hR}{{k}_{r}}$

Herein, R [m] is the radius of the heat sources 11A and 11B. kᵣ [W·m⁻¹·K⁻¹] is heat conductivity in the radial direction. h [W·m⁻²·K⁻¹] is the overall heat transfer coefficient with reference to the first surface S1 of the heat diffusion plate 10. In order to reduce temperature unevenness on the first surface S1, the heat conductivity kᵣ is preferably as large as possible, and the overall heat transfer coefficient h is preferably as small as possible.

When heat is supplied to the heat diffusion plate 10 from the heat source 11A or 11B, the heat is rapidly conducted to the peripheral edge of the heat diffusion plate 10 along the first surface S1 by the working fluid 21 in the internal space IS. The heat conductivity kᵣ of the heat diffusion plate 10 is significantly larger than that of a solid ceramic substrate having the same shape, size, and material. Therefore, even assuming that the overall heat transfer coefficient h is the same for both, the Biot number Biᵣ of the heat diffusion plate 10 is significantly smaller than that of the solid ceramic substrate having the same shape, size, and material. When considering the heat equalization time from start of heating or heat-absorbing in the heat diffusion plate 10 by the heat source 11A or 11B to completion of temperature equalization on the first surface S1, the temperature equalization time is significantly shorter than that of the solid ceramic substrate having the same shape, size, and material.

### Temperature Diffusion Coefficient

As described above, the heat conductivity kᵣ of the heat diffusion plate 10 having an internal structure illustrated in FIG. 2 is significantly larger than that of a solid ceramic substrate having the same shape, size, and material. As the heat conductivity kᵣ increases, a temperature diffusion coefficient (temperature diffusion rate) α [m²·s⁻¹] increases. $α = \frac{{k}_{r}}{{ρC}_{p}}$

Herein, ρ [kg·m⁻³] is a density, and Cₚ [J·kg⁻¹·K⁻¹] is specific heat.

The large temperature diffusion coefficient α of the heat diffusion plate 10 indicates rapid change in the temperature of the heat diffusion plate 10. Therefore, the temperature control device 1 uses the heat diffusion plate 10 to significantly shorten a time constant for following the target temperature, improve followability, and shorten a rise time (time constant), as compared with a solid ceramic substrate having the same shape, size, and material. In other words, in the temperature control device 1, the heat diffusion plate 10 has a Biot number smaller than that of a solid plate having the same shape, size, and material as the heat diffusion plate 10, and has a temperature diffusion coefficient larger than that of the solid plate having the same shape, size, and material as the heat diffusion plate 10, in such a way that the heat equalization time from start of heating or heat-absorbing in the heat diffusion plate 10 by the plurality of heat sources 11A and 11B to completion of temperature equalization on the first surface S1 is shorter than the heat equalization time for the solid plate having the same shape, size, and material as the heat diffusion plate 10. As a result, for example, when the temperature of the controlled object CO is to be increased or decreased without temperature unevenness, heating or heat-absorbing in the heat diffusion plate 10 allows the temperature of the first surface S1 to be rapidly increased or decreased, and enables rapid heat equalization.

Due to the high transient heat equalization properties of the heat diffusion plate 10, under simple control using a single heat source, the temperature of the controlled object CO is likely to overshoot or undershoot the target temperature. Therefore, as described above, the temperature control device 1 includes the heat source 11A serving as the heating source and the heat source 11B serving as the cooling source, and can suppress overshoot and undershoot of the temperature of the controlled object CO by adjusting the amounts of heat supplied from both heat sources in accordance with a deviation between the temperature of the controlled object CO and the target temperature.

As illustrated in FIG. 1, the temperature control device 1 includes a temperature sensor 12 and a controller 13.

The temperature sensor 12 detects the temperature of the controlled object CO. The temperature sensor 12 can be, for example, an infrared sensor that detects a temperature in a non-contact manner. The temperature sensor 12 can detect the temperature distribution over the entire surface of the controlled object CO and use an average thereof as a measured temperature. The temperature sensor 12 may be embedded in the heat diffusion plate 10 in order to detect the temperature of the first surface S1. In other words, the temperature sensor 12 may be any sensor capable of detecting the temperature of the controlled object CO in a contact or non-contact manner.

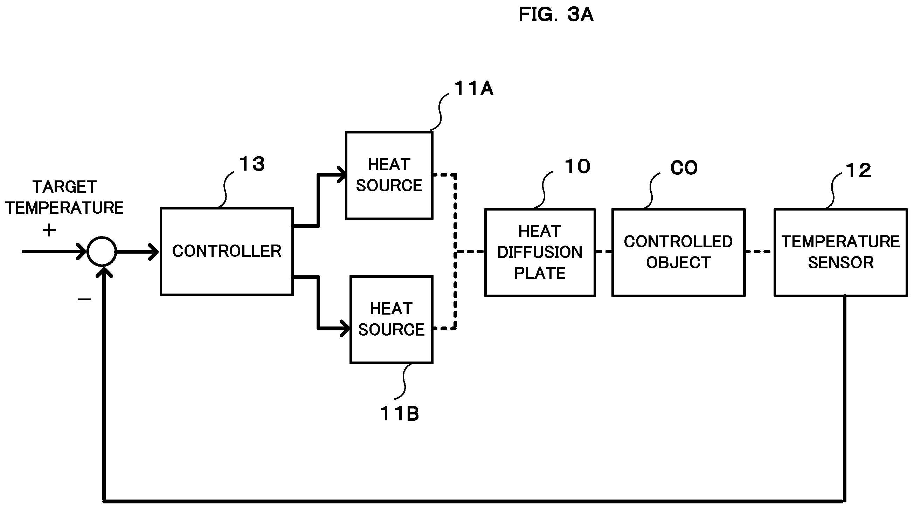

As illustrated in FIG. 3A, the controller 13 individually controls the amounts of heat supplied to the heat diffusion plate 10 from the plurality of heat sources 11A and 11B for heating or heat-absorbing, that is, independently controls the heat source 11A and the heat source 11B, based on the deviation between the temperature of the controlled object CO detected by the temperature sensor 12 and the target temperature thereof, in such a way as to shorten a response time for a transient response of the temperature of the controlled object CO following the target temperature. As this control, feedback control, more specifically, proportional-integral-differential (PID) control is used. In other words, proportional control, integral control, and derivative control of the above-described deviation are performed in such a way as to bring the deviation close to zero. The controller 13 outputs, to the heat sources 11A and 11B, a command for an amount of heat that brings the temperature of the controlled object CO close to the target temperature. Each of the heat sources 11A and 11B heats or cools the heat diffusion plate 10 in accordance with this command.

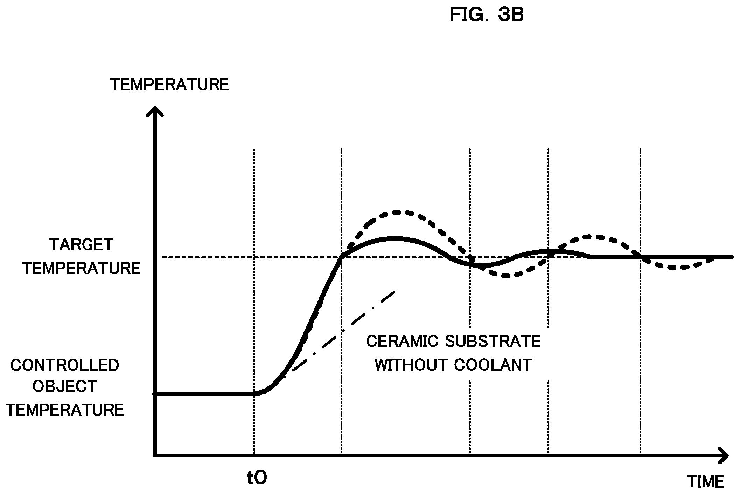

The controller 13 separately outputs a command for an amount of heat for heating the heat diffusion plate 10 to the heat source 11A and a command for an amount of heat for cooling the heat diffusion plate 10 to the heat source 11B. For example, as illustrated in FIG. 3B, when the temperature of the controlled object CO measured by the temperature sensor 12 is lower than the target temperature at a time point t0 of control start, the controller 13 performs control that prioritizes heating in the heat diffusion plate 10 by the heat source 11A. In other words, the controller 13 increases the amount of heat (heating amount) commanded to the heat source 11A for heating the controlled object CO, and decreases (for example, to zero) the amount of heat (cooling amount) commanded to the heat source 11B for cooling the controlled object CO. As a result, during the rise time, the temperature of the controlled object CO comes close to the target temperature.

When the temperature of the controlled object CO exceeds the target temperature, the sign of the deviation changes. When the temperature of the controlled object CO is higher than the target temperature, the controller 13 performs control that prioritizes cooling in the heat diffusion plate 10 by the heat source 11B. In other words, the controller 13 decreases (for example, to zero) the heating amount commanded to the heat source 11A for heating the controlled object CO, and increases the amount of heat (cooling amount) commanded to the heat source 11B for cooling the controlled object CO. This suppresses overshoot in which the temperature of the controlled object CO exceeds the target temperature, for example, as illustrated by change from a dashed line to a solid line in FIG. 3B, and shortens the duration of such overshoot.

Subsequently, when the temperature of the controlled object CO is lower than the target temperature, the controller 13 increases the amount of heat (heating amount) commanded to the heat source 11A, and then increases the amount of heat (cooling amount) commanded to the heat source 11B. This configuration can shorten the time required for the temperature of the controlled object CO to converge to the target temperature. In other words, the controller 13 can shorten the response time for the transient response of the temperature of the controlled object CO following the target temperature.

As described above, the controller 13 performs PID control in accordance with the polarity of the deviation in order to suppress overshoot and undershoot. Alternatively, adaptive PID control may be performed in which, before the polarity of the deviation reverses, the reversal of the deviation is predicted and the amounts of heat supplied from the heat sources 11A and 11B are adjusted in advance. This configuration can further reduce overshoot and undershoot.

The PID control may be provided with nonlinearity in such a way that nonlinear control is performed by increasing a proportional gain in a proportional control as a proportional component or the like of the deviation increases. Further, when an offset component remains in the deviation, the controller 13 may perform tuning control by increasing an integral constant of an integral control and, when the target temperature changes or high followability to the target temperature is required, increasing a derivative constant.

### Design Method of Temperature Control Device

A design method of the temperature control device 1 according to the present embodiment is described. In the design method, the temperature control device 1 is designed in such a way that variation in an in-plane temperature of the first surface S1 of the heat diffusion plate 10 in contact with the controlled object CO is less than or equal to a permissible value.

### Determination of Permissible Value

In the design method, first, a permissible value ΔT_{C} of variation in the temperature of the controlled object CO and the first surface S1 of the heat diffusion plate 10 needs to be determined. The permissible value ΔT_{C} is determined based on a temperature characteristic of the controlled object CO.

### Permissible Value ΔT_{C} Obtained from Variation in Reaction

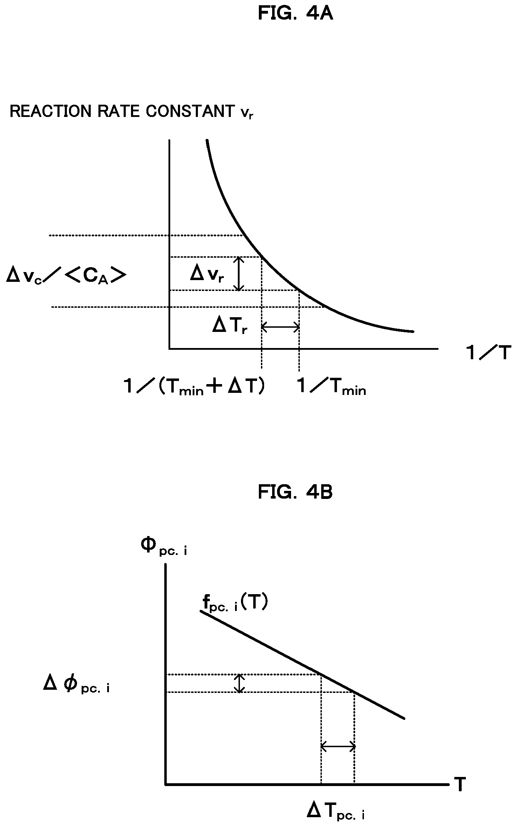

The controlled object CO is a reaction field in which substances are caused to react. In the reaction field that spreads in a planar manner, an in-plane reaction rate needs to be equalized, that is, variation in the in-plane reaction rate needs to be suppressed to less than a permissible value. The in-plane reaction rate of the controlled object CO is defined as v, and the permissible value of variation in the reaction rate v is defined as Δv_{c}. According to the Arrhenius law, dependence of a reaction rate constant vᵣ in the controlled object CO on a temperature T is given by the following equation (1). FIG. 4A illustrates a curve representing the equation (1).
[Math 3] ${v}_{r} = {A}_{r} exp \left(-\frac{{E}_{a}}{RT}\right)$

Herein, Aᵣ is a frequency factor, Ea [J·mol⁻¹] is activation energy, R [J·K⁻¹·mol⁻¹] is a gas constant, and T [K] is the temperature of the controlled object CO.

The unit of the frequency factor Aᵣ varies depending on an order of a reaction. For example, when the reaction assumed herein is a first-order reaction, the unit of the frequency factor Aᵣ is [S⁻¹]. In this case, when a concentration of a reactant is C_{A} [mol·m⁻³], the reaction rate v is represented by the following equation.
[Math 4] $v = {v}_{r} {C}_{A}$

From this equation, variation Δv in the reaction rate v is represented by the following equation.
[Math 5] $Δv = Δ \left({v}_{r}{C}_{A}\right) = {Δv}_{r} \left〈{C}_{A}\right〉 + \left〈{v}_{r}\right〉 {ΔC}_{A} + {Δv}_{r} {ΔC}_{A}$

Herein, <vᵣ> and <C_{A}> are average values of the in-plane reaction rate constant vᵣ and the concentration C_{A}, respectively, at a radius r. When second-order minute amounts Δvᵣ and ΔC_{A} are smaller than others and small to a negligible degree, the following equation is obtained from the equation (3).
[Math 6] $Δv = {Δv}_{r} \left〈{C}_{A}\right〉 + \left〈{v}_{r}\right〉 {ΔC}_{A}$

The permissible value of variation in the reaction rate in the reaction field is defined as Δη. In this case, the variation Δv in the reaction rate v needs to satisfy a condition represented by the following equation. ${\int }_{0}^{{t}_{p}} Δv dt < Δ η$ tₚ is a reaction time. The variation Δv in the reaction rate v satisfying the condition equation corresponds to the permissible value Δv_{c} of the variation in the reaction rate v in the above-described equation (4). Therefore, the following equation is obtained from the above-described equation (4). $Δv = {Δv}_{r} \left〈{C}_{A}\right〉 + \left〈{v}_{r}\right〉 {ΔC}_{A} < {Δv}_{c}$

The equation is converted as follows. ${Δv}_{r} + \left〈{v}_{r}\right〉 \frac{{ΔC}_{A}}{\left〈{C}_{A}\right〉} < \frac{{Δv}_{c}}{\left〈{C}_{A}\right〉}$

When the unevenness ΔC_{A} of the in-plane concentration is sufficiently small relative to the average concentration <C_{A}>, the following equation is obtained from the equation (5).
[Math 10] ${Δv}_{r} < \frac{{Δv}_{c}}{\left〈{C}_{A}\right〉}$

Herein, when a minimum value of the in-plane temperature of the heat diffusion plate 10 is defined as Tₘᵢₙ [K] and a maximum value is defined as Tₘₐₓ [K], ΔT = Tₘₐₓ - Tₘᵢₙ as illustrated in FIG. 4A, and
[Math 11] ${Δv}_{r} = {A}_{r} \left\{exp\left(-\frac{{E}_{a}}{R \left({T}_{min}+ΔT\right)}\right)-exp\left(-\frac{{E}_{a}}{{RT}_{min}}\right)\right\}$ is derived from the equation (1). Thus, a condition to be satisfied by the variation ΔT in the in-plane temperature T is given by the following equation.
[Math 12] ${A}_{r} \left\{exp\left(-\frac{{E}_{a}}{R \left({T}_{min}+ΔT\right)}\right)-exp\left(-\frac{{E}_{a}}{{RT}_{min}}\right)\right\} < \frac{{Δv}_{c}}{\left〈{C}_{A}\right〉}$

Herein, an upper limit value of ΔT satisfying the equation (8) is a permissible value ΔTᵣ of temperature variation. A range of ΔT satisfying the equation (8) can be determined by using a solution method such as a bisection method. Therefore, by the above-described procedures, the permissible value ΔTᵣ of the temperature variation when the controlled object CO is the reaction field can be determined.

As illustrated in FIG. 4B, temperature dependence of a physical property value Φ_{pc.i} (pc.i = 1, 2, 3, ..., n: n is any integer) of a substance included in the controlled object CO is given by the following equation (9).
[Math 13] ${ϕ}_{pc . i} = {f}_{pc . i} \left(T\right)$

Herein, f_{pc.i}(T) is a function of the temperature T [K]. One example of the function f_{pc.i}(T) is illustrated in FIG. 4B. When a permissible value (minute amount) of variation in the in-plane physical property value Φₚᵢ is ΔΦ_{pc.i}, a permissible value ΔT_{pc.i} of temperature variation for satisfying ΔΦ_{pc.i} needs to satisfy the following condition.
[Math 14] ${f}_{pc . i} \left({ΔT}_{pc . i}\right) < {Δϕ}_{pc . i}$

Therefore, among the permissible value ΔTᵣ of temperature variation determined from the permissible value Δvᵣ that is a minute amount of the variation Δv in the reaction rate v, and the permissible value ΔT_{pc.i} (pc.i = 1, 2, 3, ..., n) of temperature variation determined from the permissible value of variation in the physical property value, the smallest value is the permissible value ΔT_{c} of variation in the in-plane temperature T of the first surface S1 for the controlled object CO. Herein, the permissible value of variation in the in-plane temperature T of the first surface S1 can be determined to be ΔT_{c}.

The temperature T [K] in the above-described equations (1) to (10) is the temperature of the controlled object CO. When the controlled object CO is thin, the temperature of the controlled object CO and the temperature of the first surface S1 of the heat diffusion plate 10 are almost the same. In a case where a thickness of the controlled object CO is not negligible, the following relationship holds true based on continuity of a heat flux when a heat transfer coefficient of a surface of the controlled object CO opposite to the heat diffusion plate 10 is defined as Uₜₒₚ, the temperature of the heat diffusion plate 10 is defined as T, the temperature of the controlled object CO on an opposite side to the heat diffusion plate 10 is defined as T_{top,} heat conductivity of the controlled object CO in a thickness direction is defined as kₜ, and the thickness of the controlled object CO is δₜ,. ${k}_{t} \frac{\left|T-{T}_{top}\right|}{{δ}_{t}} = {U}_{top} \left|{T}_{top}-{T}_{∞}\right|$

Thus, for example, when T > Tₜₒₚ and Tₜₒₚ > T_{∞}, the following equation is obtained for Ttop $T - {T}_{top} = \frac{{U}_{top} {δ}_{t}}{{k}_{t}} \left({T}_{top}-{T}_{∞}\right)$

The equation is converted as follows. ${T}_{top} = \frac{1}{1 + \frac{{U}_{top} {δ}_{t}}{{k}_{t}}} \left(T+\frac{{U}_{top} {δ}_{t}}{{k}_{t}}{T}_{∞}\right)$

When the thickness of the controlled object CO is not negligible, T [K] in the above-described equations (1) to (10) needs to be calculated on an assumption that T [K] corresponds to Tₜₒₚ.

### Design Parameter of Temperature Control Device

A design parameter related to the size and heat transfer of the temperature control device 1 satisfying the permissible value ΔT_{C} of variation in the in-plane temperature T of the first surface S1 can be determined, for example, as follows.

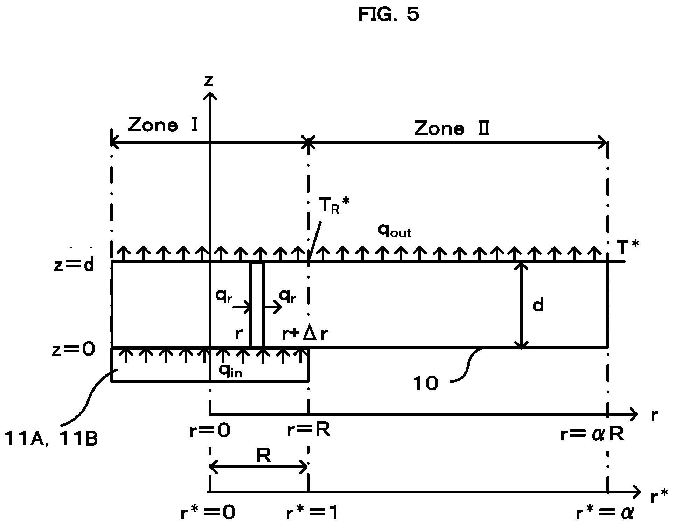

As illustrated in FIG. 5, a differential section between a position r with reference to a central point of the heat diffusion plate 10 in the radial direction and a position r + Δr is considered. The differential section forms a shell having a double cylindrical shape. The plate thickness of the heat diffusion plate 10 is defined as d. In the shell, with respect to a direction of the radius r, a heat amount qᵣ enters from the position r by heat conduction, and the heat amount qᵣ exits from the position r + Δr. Further, an amount of heat supplied from the heat sources 11A and 11B is defined as qᵢₙ, and an amount of heat supplied to the controlled object CO from the heat diffusion plate 10 is defined as q_{out.} Furthermore, in the shell, heat is transferred in a thickness direction from a section in contact with the heat sources 11A and 11B, and the heat amount exits from a section in contact with the controlled object CO. In this case, a governing equation of heat energy storage of in the shell in a steady state can be defined as follows.
[Math 18] $\begin{matrix}{\left.\left(2{πrdq}_{r}\right)\right|}_{r} - {\left.\left(2{πrdq}_{r}\right)\right|}_{r + Δr} + 2 πr Δ r \left({q}_{in}-{q}_{out}\right) = \\ 0\end{matrix}$

The following equation is obtained by dividing both sides of the above-described equation by 2πrdΔr and bringing Δr close to 0.
[Math 19] $\frac{d}{dr} \left({rq}_{r}\right) + \frac{r}{d} \left({q}_{in}-{q}_{out}\right) = 0$

According to the Fourier's law concerning heat conduction, qᵣ [W·m⁻²] is as follows. As described above, kᵣ is the heat conductivity in the radial direction.
[Math 20] ${q}_{r} = - {k}_{r} \frac{dT}{dr}$

According to the Newton's law, qₒᵤₜ [W·m⁻²] is as follows.
[Math 21] ${q}_{out} = h \left(T-{T}_{∞}\right)$

As described above, h [W·m⁻²·K⁻¹] is the overall heat transfer coefficient with reference to the first surface S1 of the heat diffusion plate 10. When assuming that the heat conductivity kᵣ [W·m⁻¹·K⁻¹] and the overall heat transfer coefficient h [W·m⁻²·K⁻¹] are constant in the heat diffusion plate 10, the above-described equation (12) is as follows.
[Math 22] $r \frac{{d}^{2} T}{{dr}^{2}} + \frac{dT}{dr} + r \frac{h}{{k}_{r} d} \left(T-{T}_{∞}-\frac{{q}_{in}}{h}\right)$

Herein, a surface temperature of the controlled object CO on the first surface S1 at the radius r [m] is defined as T*(r) [K]. The surface temperature T*(r) [K] is defined as follows.
[Math 23] $T * \left(r\right) = T \left(r\right) - {T}_{∞} - \frac{{q}_{in . eff}}{h}$

Herein, T(r) [K] is the temperature of the heat diffusion plate 10 at the radius r, and T_{∞} [K] is a reference temperature.

q_{in.eff} is a net value obtained by offsetting the heating and heat removal amounts from the plurality of heat sources 11A and 11B to the heat diffusion plate 10. qᵢₙ [W·m⁻²] is a heat flux of each of the heat sources 11A and 11B when heat is supplied to the heat diffusion plate 10, and Sᵢₙ [m²] is the area of the region 11a. ${q}_{in . eff} = \frac{1}{{S}_{in}} {∬}_{{S}_{in}} {q}_{in} ds$

When the reference temperature T_{∞} [K] and qᵣ [W·m⁻²] are also constant, the following equation is obtained from the equation (15).
[Math 25] $r \frac{{d}^{2} {T}^{∗}}{{dr}^{2}} + \frac{{dT}^{∗}}{dr} + r \frac{h}{{k}_{r} d} {T}^{∗}$

The temperature at an end portion (r = R) of the heat sources 11A and 11B is defined as T*_{R} [K], and a dimensionless temperature θ [-] with reference to T*_{R} [K] is defined by the following equation.
[Math 26] $Θ = \frac{{T}^{∗}}{{{T}^{∗}}_{R}}$

With reference to the radius R [m] of the heat sources 11A and 11B, a dimensionless radius r* is defined by the following equation.
[Math 27] ${r}^{∗} = \frac{r}{R}$

The following equation is obtained from the equation (16) by using the equation (18A) and the equation (18B).
[Math 28] ${r}^{*} \frac{{d}^{2} Θ}{dr {*}^{2}} + \frac{dΘ}{dr *} + r * \frac{hR}{{k}_{r}} \frac{R}{d} Θ = 0$

The Biot number Biᵣ in the radial direction is defined by the following equation. [Math 29] ${Bi}_{r} = \frac{hR}{{k}_{r}}$

From the Biot number Biᵣ, a design parameter a is defined by the following equation.
[Math 30] $a = {Bi}_{r} \frac{R}{d}$

Herein, R [m] is the radius of the heat sources 11A and 11B, as described above. d [m] is the thickness of the heat diffusion plate 10, as described above. Further, α is defined as a ratio of the radius r of the heat diffusion plate 10 to the radius R of the heat sources 11A and 11B.
[Math 31] $r * \frac{{d}^{2} Θ}{dr {*}^{2}} + \frac{dΘ}{dr *} + ar {*}^{2} Θ \left({r}^{*}\right) = 0$

The following equation is obtained as a general solution of the above-described equation (22).
[Math 32] $Θ \left(r*\right) = {C}_{1} {I}_{0} \left(\sqrt{a}r*\right) + {C}_{2} {K}_{0} \left(\sqrt{a}r*\right)$

Herein, I₀ is a first kind of zeroth-order modified Bessel function. K₀ is a second kind of zeroth-order modified Bessel function.

The following equation is obtained by differentiating the above-described equation (22).
[Math 33] $\frac{d Θ}{dr *} = \sqrt{a} \left\{{C}_{1}{I}_{0}\left(\sqrt{a}r*\right)+{C}_{2}{K}_{1}\left(\sqrt{a}r*\right)\right\}$

Herein, I₁ is a first kind of first-order modified Bessel function. K₁ is a second kind of first-order modified Bessel function.

As illustrated in FIG. 5, the first surface S1 can be divided into the following two regions.
Region (Zone) I (0 ≤ r ≤ R): Central region to which heat is transferred from a bottom surface
Region (Zone) II (R ≤ r): Peripheral region to which heat is not transferred from the bottom surface

In the region I, a second term of the equation (22) diverges to +∞ as r* comes close to +0. Since Θ^{I}(r) is a bounded function, C₂ needs to be 0. Thus, the second term of the equation (22) in the region I is 0. Further, Θ^{I}(r*) is 1 when r* = 1, and is thus defined by the following equation.
[Math 34] ${Θ}^{I} \left(r*\right) = \frac{{I}_{0} \left(\sqrt{a}r*\right)}{{I}_{o} \left(\sqrt{a}\right)}$

Further, Θ^{II}(r*) is derived as follows from a boundary condition of an end portion (r* = α) of the heat diffusion plate 10 according to the Newton's law and various boundary conditions such as a condition where Θ^{II} = 1 when r* = 1.
[Math 35] $\begin{matrix}{Θ}^{II} \left(r*\right) \\ = \frac{\left\{\sqrt{a}{K}_{1}\left(\sqrt{a}α\right)-{Bi}_{r}{K}_{0}\left(\sqrt{a}α\right)\right\} {I}_{0} \left(\sqrt{a}r*\right) + \left\{\sqrt{a}{I}_{1}\left(\sqrt{a}α\right)+{Bi}_{r}{I}_{0}\left(\sqrt{a}α\right)\right\} {K}_{0} \left(\sqrt{a}r*\right)}{\left\{\sqrt{a}{K}_{1}\left(\sqrt{a}α\right)-{Bi}_{r}{K}_{0}\left(\sqrt{a}α\right)\right\} {I}_{0} \left(\sqrt{a}\right) + \left\{\sqrt{a}{I}_{1}\left(\sqrt{a}α\right)+{Bi}_{r}{I}_{0}\left(\sqrt{a}α\right)\right\} {K}_{0} \left(\sqrt{a}\right)}\end{matrix}$

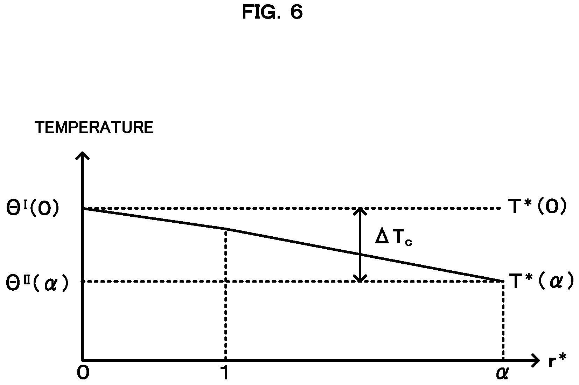

As illustrated in FIG. 6, in the heat diffusion plate 10, a maximum point of the in-plane temperature is a central portion in contact with a central portion of the heat sources 11A and 11B, and is given by Θ^{I}(0). A minimum point of the temperature is an end portion (r = αR) of the heat diffusion plate 10, and is given by Θ^{II}(α). Therefore, a dimensionless in-plane temperature unevenness ΔΘ is given by the following equation. $ΔΘ = {Θ}^{I} \left(0\right) - {Θ}^{II} \left(α\right)$

Θ^{I}(0) and Θ^{II}(α) can be determined by the equation (25) and the equation (26), respectively.

After Θ^{I}(0) and Θ^{II}(α) are determined, the surface temperature T*(r*) [K] of the first surface S1 at each point when r* = 0 and r* = α is obtained as follows from the equation (18A).
[Math 37] $T * \left(0\right) = T \left(0\right) - {T}_{∞} - \frac{{q}_{in . eff}}{h} = {Θ}^{I} \left(0\right) T {*}_{R} = {Θ}^{I} \left(0\right) \left\{\begin{matrix}T \\ \left(R\right) - {T}_{∞} - \frac{{q}_{in . eff}}{h}\end{matrix}\right\}$ [Math 38] $T * \left(α\right) = T \left(α\right) - {T}_{∞} - \frac{{q}_{in . eff}}{h} = {Θ}^{II} \left(α\right) T {*}_{R} = {Θ}^{II} \left(α\right) \left\{\begin{matrix}T \\ \left(R\right) - {T}_{∞} - \frac{{q}_{in . eff}}{h}\end{matrix}\right\}$

The in-plane temperature unevenness ΔT of the first surface S1 is given by the following equation.
[Math 39] $ΔT = T * \left(0\right) - T * \left(α\right) = T \left(0\right) - T \left(α\right) = \left\{{Θ}^{I}\left(0\right)-{Θ}^{II}\left(α\right)\right\} \left\{\begin{matrix}T \\ \left(R\right) - {T}_{∞} - \frac{{q}_{in . eff}}{h}\end{matrix}\right\}$

Herein, the target temperature of the controlled object CO is defined as a boundary condition T(R) of the temperature of the heat diffusion plate 10, the predetermined reference temperature is defined as T_{∞}, and the net input heat flux from the heat sources 11A and 11B is defined as q_{in.eff}. These values can be used as given design conditions. Θ^{I}(0) and Θ^{II}(α) are determined when a, α, and the Biot number Bᵢᵣ are determined. α is determined when the radius of each of the heat diffusion plate 10 and the heat sources 11A and 11B is determined. a is determined when d, R, and the Biot number Biᵣ are determined.

Therefore, in the design method, when T(R), T_{∞}, and q_{in.eff} are used as the given design conditions and, furthermore, the design parameters d, R, and α related to the sizes of the heat diffusion plate 10 and the heat sources 11A and 11B are determined, an upper limit value Bi_{r.MAX} of the Biot number Bᵢᵣ satisfying ΔT = ΔT_{c} can be determined from the equation (29), as illustrated in FIG. 6.

When the upper limit value B_{ir.MAX} of the Biot number Bᵢᵣ is obtained, the design condition of the temperature control device 1 can be determined by determining the heat conductivity kᵣ and the overall heat transfer coefficient h in the surface direction of the heat diffusion plate 10 in such a way as to satisfy the following equation (30).
[Math 40] $\frac{hR}{{k}_{r}} < {Bi}_{r . MAX}$

Therefore, the equation (29) and the equation (30) are calculation equations representing a relationship among an ambient temperature T_{∞} around the controlled object CO, the target temperature T(R) of the controlled object CO, the input heat amount q_{in.eff} from the heat sources 11A and 11B to the heat diffusion plate 10, the design parameters d, R, and α related to the sizes of the heat diffusion plate 10 and the heat sources 11A and 11B, the heat conductivity kᵣ and the overall heat transfer coefficient h of the heat diffusion plate 10, and the permissible value ΔT_{c} of variation in the temperature T [K] on the first surface S1. The design parameters d, R, α, kᵣ, and h can be determined by using the equation (29) and the equation (30).

### Flow of Design of Temperature Control Device 1

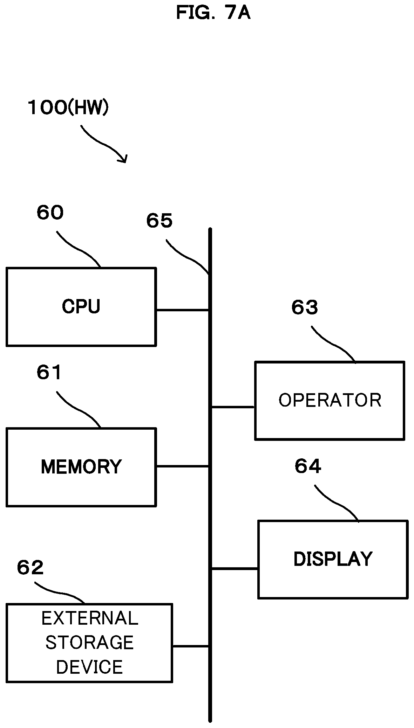

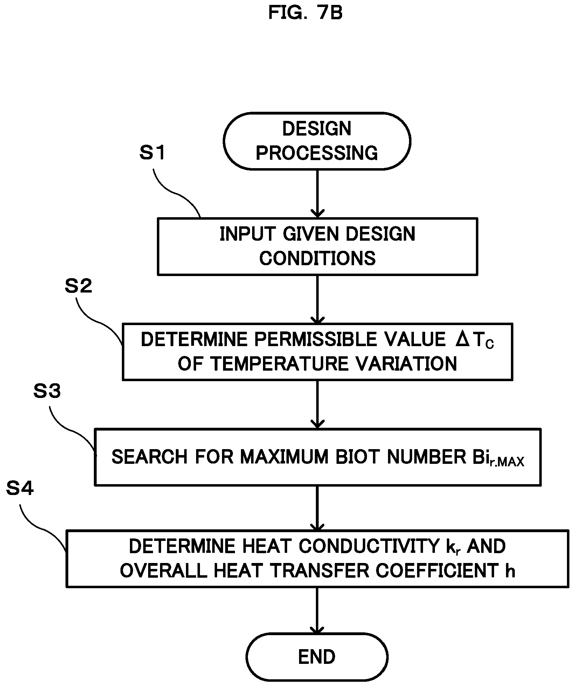

As illustrated in FIG. 7A, design of the temperature control device 1 is performed by an information processing device 100. The information processing device 100 is implemented by a CPU 60 executing a software program read from an external storage device 62 into a memory 61 in accordance with an operation via an operator 63 in a computer HW including the CPU 60, the memory 61, the external storage device 62, the operator 63, a display 64, and an internal bus 65. A result of design processing of the temperature control device 1 performed by the CPU 60 is displayed on, for example, the display 64. The information processing device 100 in which the function is implemented by the computer executing the program performs the design processing (design method) of the temperature control device 1 illustrated in FIG. 7B.

As illustrated in FIG. 7B, first, the information processing device 100 inputs the given design conditions such as the ambient temperature T_{∞}, the input heat amount qᵢₙ from the heat sources 11A and 11B, the target temperature T(R) of the controlled object CO, and the design parameters d, R, and α related to the sizes of the heat diffusion plate 10 and the heat sources 11A and 11B (step S1).

Next, the information processing device 100 determines, based on the relationships represented by the equation (1) to the equation (8), the permissible value ΔTᵣ of temperature unevenness corresponding to variation Δr_{c} in a reaction value, obtains ΔT_{pc.i} satisfying Δφ_{pc.i} based on f_{pc.i}(T) in the equation (9) and the equation (10), and determines a minimum value among ΔTᵣ and ΔT_{pc.i} to be the permissible value ΔT_{c} of temperature variation (step S2). In other words, the information processing device 100 sets the permissible value ΔT_{c} of in-plane temperature variation of the controlled object CO, based on a temperature characteristic of the physical property value of the controlled object CO or a characteristic of the in-plane reaction rate when the controlled object CO is a reaction field.

Next, the information processing device 100 searches for the maximum Biot number Bi_{r.MAX} satisfying ΔT = T_{c} by using the above-described equation (29) (step S3). The maximum Biot number Bi_{r.MAX} is the Biot number Bi when ΔT = T_{c}. For example, the bisection method is used for the search for the maximum Biot number Bi_{r.MAX}.

In the bisection method, an evaluation function is defined as F = ΔT - ΔT_{c}. In this case, F is a monotonically increasing function of Bi. The bisection method is performed by the following procedures.

Procedure 1) As initial values of both ends of a solution section of the Biot number Biᵣ, a sufficiently small appropriate Biot number Biᵣ₁ (for example, 10⁻⁶) and a sufficiently large appropriate Biot number Biᵣ₂ (for example, 10⁶) are given, and when F, that is, F(Biᵣ₁) obtained by substituting the Biot number Biᵣ₁ in the equation (29) is not a negative value, Biᵣ₁ continues to be divided by 2 until F(Biᵣ₁) becomes a negative value. When F(Biᵣ₂) is a negative value, Biᵣ₂ continues to be doubled until F(Biᵣ₂) becomes positive.

Procedure 2) F at an intermediate value Biᵣₘ = (Biᵣ₁ + Biᵣ₂)/2 between Biᵣ₁ and Biᵣ₂, that is, F(Biᵣₘ) is calculated by using the equation (29). Depending on whether F(Biᵣₘ) is positive or negative, the solution section is updated in accordance with the following rules.
- When φ(Biᵣₘ) < 0, Biᵣₘ is set as a new Biᵣ₁.
- When φ(Biᵣₘ) ≥ 0, Biᵣₘ is set as a new Biᵣ₂.

Procedure 3) Biᵣₘ is obtained from the newly determined Biᵣ₁ and Biᵣ₂.

Procedure 4) The procedure 2 to the procedure 3 are repeated until Biᵣ₂ - Biᵣ₁ falls below a threshold value (for example, 10⁻⁶).

Procedure 5) A final value of Biᵣₘ is adopted as a search result of a convergent value of the maximum Biot number Bi_{r.MAX}, and the search for the maximum Biot number Bi_{r.MAX} ends.

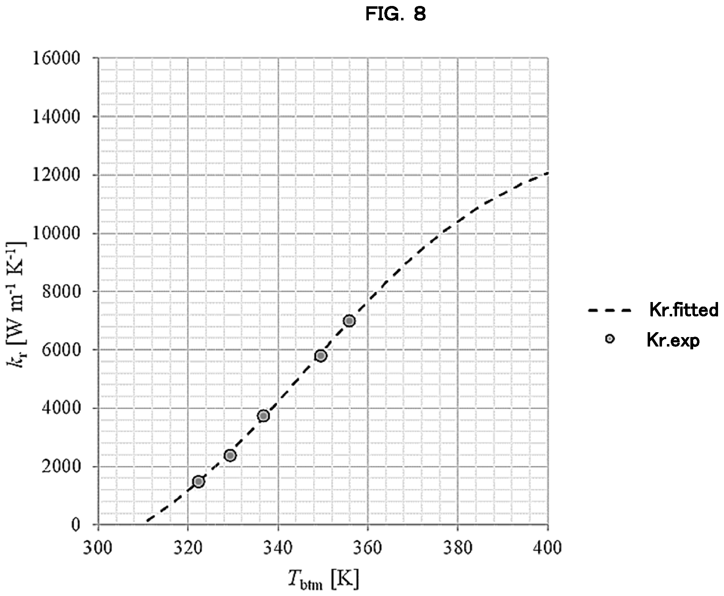

Next, the information processing device 100 inputs the maximum Biot number Bi_{r.MAX} into the equation (30), and determines the heat conductivity kᵣ and the overall heat transfer coefficient h satisfying the equation (30) (step S4). The heat conductivity kᵣ can be determined by using, for example, a temperature characteristic illustrated in FIG. 8 in such a way as to correspond to the target temperature T(R) of the controlled object CO.

Although the Biot number Biᵣ serves as a search target in the present embodiment, a configuration may be provided in which the heat conductivity kᵣ corresponding to the target temperature T(R) of the controlled object CO is first determined based on the temperature characteristic illustrated in FIG. 8, and the overall heat transfer coefficient h is then searched as described above to obtain the maximum Biot number Bi_{r.MAX}. Not only the Biot number Biᵣ, but also any one of the radius R of the heat sources 11A and 11B, the thickness d of the heat diffusion plate 10, and the ratio α of the radius of the heat diffusion plate 10 to the radius of the heat sources 11A and 11B may serve as a search target.

### Design Example

For example, design conditions are determined as follows.
- Diameter 2R of heat sources 11A and 11B: 55 mm
- Diameter (2αR) of heat diffusion plate 10 and controlled object CO: 60 mm
- Permissible value ΔT_{C} of in-plane temperature unevenness: 0.1 K
- Target temperature T(R) of controlled object CO: 350 K
- Environmental temperature T_{∞} : 298 K

When these conditions are input into the equation (29), the maximum Biot number Bi_{r.MAX} is 2.321 × 10⁻³². Further, a minimum value of the heat conductivity kᵣ satisfying the condition of the maximum Biot number Bi_{r.MAX} is 1.185 × 10³ [W·m⁻¹·K⁻¹]. Temperature dependence of the heat conductivity kᵣ of the heat diffusion plate 10 made of ceramics is given in FIG. 8. In FIG. 8, kr.exp is an experimental value, and kr.fitted is a fitting curve representing a characteristic. Herein, when a temperature T_{btm} of the heat diffusion plate 10 corresponding to the given design condition is 350 [K], the heat conductivity kᵣ is 5.987 × 10³ [W·m⁻¹·K⁻¹]. This value is larger than a minimum value (value corresponding to the maximum Biot number Bi_{r.MAX}) to be satisfied by kᵣ, and satisfies a necessary condition. Since in-plane temperature unevenness of the controlled object CO in this case is 0.0201 [K], it is obvious that the heat diffusion plate 10 can achieve temperature unevenness of the controlled object CO less than or equal to the permissible value.

The temperature control device 1 designed by the above-described design method has sizes of the heat diffusion plate 10 and the plurality of heat sources 11A and 11B and heat conductivity kᵣ and an overall heat transfer coefficient h of the heat diffusion plate 10 that are determined based on the characteristic equations representing the relationship among the ambient temperature T_{∞} around the controlled object CO, the target temperature T(R) of the controlled object CO, the input heat amount q_{in.eff} from the plurality of heat sources 11A and 11B to the heat diffusion plate 10, the sizes of the heat diffusion plate 10 and the plurality of heat sources 11A and 11B, the heat conductivity kᵣ and the overall heat transfer coefficient h of the heat diffusion plate, and the temperature variation on the first surface S1, in such a way that, when the ambient temperature T_{∞}, the target temperature T(R), and the net input heat amount q_{in.eff} serve as the given design conditions, a difference between a maximum temperature T*(0) and a minimum temperature T*(α) of a portion of the first surface S1 in contact with the controlled object CO falls within the permissible value of the in-plane temperature variation of the controlled object CO.

The temperature control device 1 includes the controller 13 that controls the temperature of the controlled object CO to follow the target temperature T(R), and also includes the heat source 11A that heats the heat diffusion plate 10 and the heat source 11B that cools the heat diffusion plate 10. The temperature control device 1 individually controls the heat source 11A and the heat source 11B based on the deviation between the temperature of the controlled object CO and the target temperature. This enables not only rapid temperature control than with a single heat source, but also highly accurate temperature control, such as preventing overshoot or undershoot of temperature that is difficult to prevent with a single heat source when differential control is performed in PID control. As a result, temperature stress caused by excessive heating or cooling of the controlled object CO can be suppressed.

As described in detail above, in the present embodiment, the heat diffusion plate 10 has a configuration in which the housing 20 is made of a material containing any one of ceramics, a ceramic composite material, and an inorganic substance except for metal (hereinafter, simply referred to as "ceramics or the like" as appropriate) and the working fluid 21 carrying heat circulates in the internal space IS of the housing 20 along the first surface S1. This configuration can reduce the Biot number Biᵣ and increase the temperature diffusion coefficient α. This can shorten the heat equalization time from start of heating or heat-absorbing to the time when the temperature unevenness of the first surface S1 reaches a steady state, and thus enables rapid heat equalization in the controlled object CO.

The temperature control device 1 includes the heat source 11A that serves as the heating source for heating the heat diffusion plate 10, and the heating source 11B that serves as the cooling source for cooling the heat diffusion plate 10. Thus, the temperature control device 1 can control the temperature of the controlled object CO to the target temperature T(R) regardless of the ambient temperature T_{∞} around the controlled object CO.

Further, the plurality of heat sources for transferring heat to the heat diffusion plate 10 includes the heat source 11A for heating the heat diffusion plate and the heat source 11B for cooling the heat diffusion plate. The controller 13 can individually drive the respective heat sources to suppress overshoot and undershoot of the temperature of the controlled object relative to the target temperature. This allows the temperature of the controlled object to follow quickly the target temperature while suppressing overshoot or undershoot.

In the temperature control device 1, the heat diffusion plate 10 is made of any one of ceramics, a ceramic composite material, and an inorganic substance except for metal (ceramics or the like). This configuration can suppress, due to a low expansion or high rigidity characteristic of ceramics or the like, warpage of the heat diffusion plate 10 that is a factor of deterioration of the heat transfer coefficient when a rapid temperature change occurs in the heat diffusion plate. The heat diffusion plate 10 has a high specific rigidity with reference to its light weight, and is thus suitable for environments where light weight and resistance to deformation are required. Further, the heat diffusion plate 10 is made of ceramics or the like, and is thus highly resistant to corrosion. Therefore, various fluids can be used as the working fluid 21. Furthermore, the heat diffusion plate 10 made of ceramics or the like can provide a reaction field with high chemical stability. Furthermore, ceramics or the like has low swelling properties, and can be used in water-rich environments. In particular, ceramics are suitable for use in portions where insulation is required.

### Modified Examples

The configuration of the temperature control device 1 is not limited to that illustrated in FIG. 1, and various modifications can be made thereto. Modified examples of the temperature control device 1 are described below.

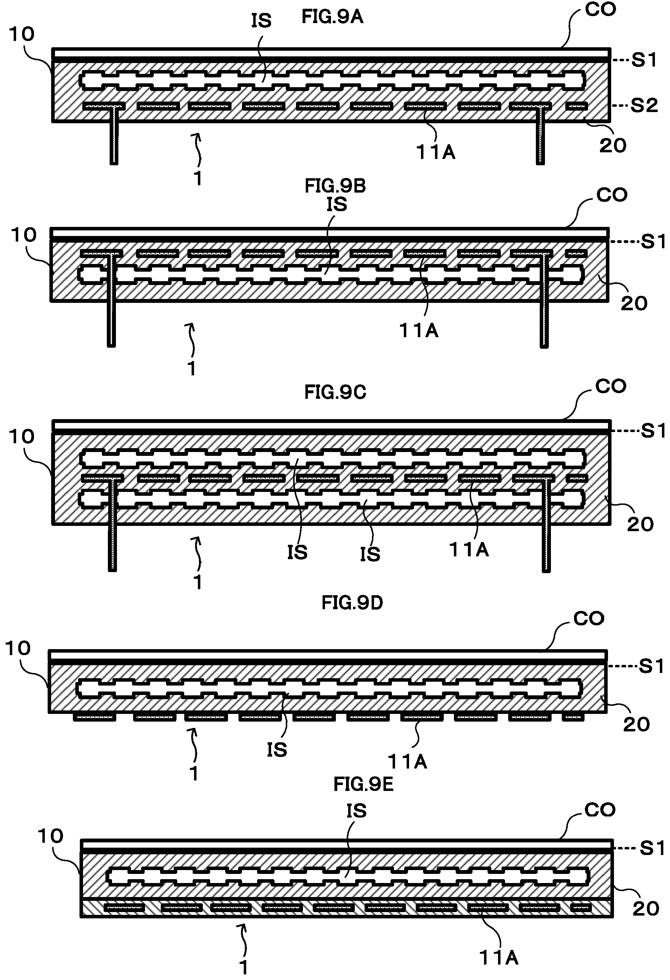

FIGS. 9A to 9E illustrate modified examples of arrangement of the heat diffusion plate 10 and the heat source 11A serving as an electrode heater. Illustration of the heat source 11B is omitted in FIGS. 9A to 9E.

In the configuration illustrated in FIG. 9A, the heat source 11A is mounted and incorporated in the housing 20 of the heat diffusion plate 10. In this case, the heat source 11B may be disposed in place of the heat source 11A. In other words, in the temperature control device 1, at least one of the plurality of heat sources 11A and 11B can be integrated with the heat diffusion plate 10 and mounted in the housing 20.

Specifically, the heat sources 11A and 11B can be integrated with the heat diffusion plate 10 by forming housings of the heat sources 11A and 11B of the same material as the material of the housing 20 of the heat diffusion plate 10 and directly bonding the heat sources 11A and 11B and the housing 20 of the heat diffusion plate 10 on the second surface S2. Further, a configuration may be provided in which the heat sources 11A and 11B are formed by screen-printing a heater circuit on a ceramics substrate and the heat diffusion plate 10 and the heat sources 11A and 11B are integrated by simultaneous sintering.

This configuration allows the heat source 11A to transfer heat to the housing 20 from inside the housing 20 and quickly conduct heat to the heat diffusion plate 10. The heat source 11B serving as a cooling source may be mounted in the housing 20. As illustrated in FIG. 9A, a plurality of heat sources 11A can be disposed on a surface opposite to the first surface S1 with the internal space IS interposed therebetween. In this manner, at least one of the plurality of heat sources 11A and 11B can be disposed on the second surface S2 opposite to the first surface S1 with the internal space IS interposed therebetween.

In the configuration illustrated in FIG. 9B, the heat source 11A is disposed between the first surface S1 and the internal space IS. Even in this configuration, the heat diffusion plate 10 can achieve heat equalization in the controlled object CO. In the temperature control device 1, at least one of the plurality of heat sources 11A and 11B may be disposed between the first surface S1 and the internal space IS.

In the configuration illustrated in FIG. 9C, the housing 20 includes two internal spaces IS stacked on the first surface S1. In other words, the housing 20 includes a partition that divides the internal space IS into two spaces in a direction intersecting the first surface S1. The heat source 11A is then mounted on the partition between the two internal spaces IS in the housing 20. This configuration allows the working fluid 21 to transport heat in a direction along the first surface S1 on both surfaces of the heat source 11A. The heat source 11B may be disposed between the internal spaces IS in place of the heat source 11A, or both the heat sources 11A and 11B may be disposed between the internal spaces IS. In other words, at least one of the plurality of heat sources 11A and 11B can be mounted on the partition between the two internal spaces in the housing 20.

In the configuration illustrated in FIG. 9D, the heat source 11A is mounted on an outer surface parallel to the first surface S1 in the housing 20. In this case, the heat source 11A is formed as an electrode pattern on the outer surface of the housing 20. This configuration can eliminate a process of incorporating the heat source 11A into the housing 20. The heat source 11B may be disposed in place of the heat source 11A. In other words, at least one of the plurality of heat sources 11A and 11B can be mounted on the outer surface parallel to the first surface S1 in the housing 20.

In the configuration illustrated in FIG. 9E, the heat source 11A is formed separately from the housing 20. In this configuration, the heat source 11A formed separately from the housing 20 may be installed in the housing 20 via a thermal interface material (TIM). The TIM is a thermally conductive material used to fill a space between two materials or to bring the two materials into close contact with each other. This configuration can facilitate heat transfer from the heat source 11A to the housing 20. The same also applies between the housing 20 and the controlled object CO. The heat source 11B may be disposed in place of the heat source 11A. In other words, at least one of the plurality of heat sources 11A and 11B can be formed separately from the housing 20.

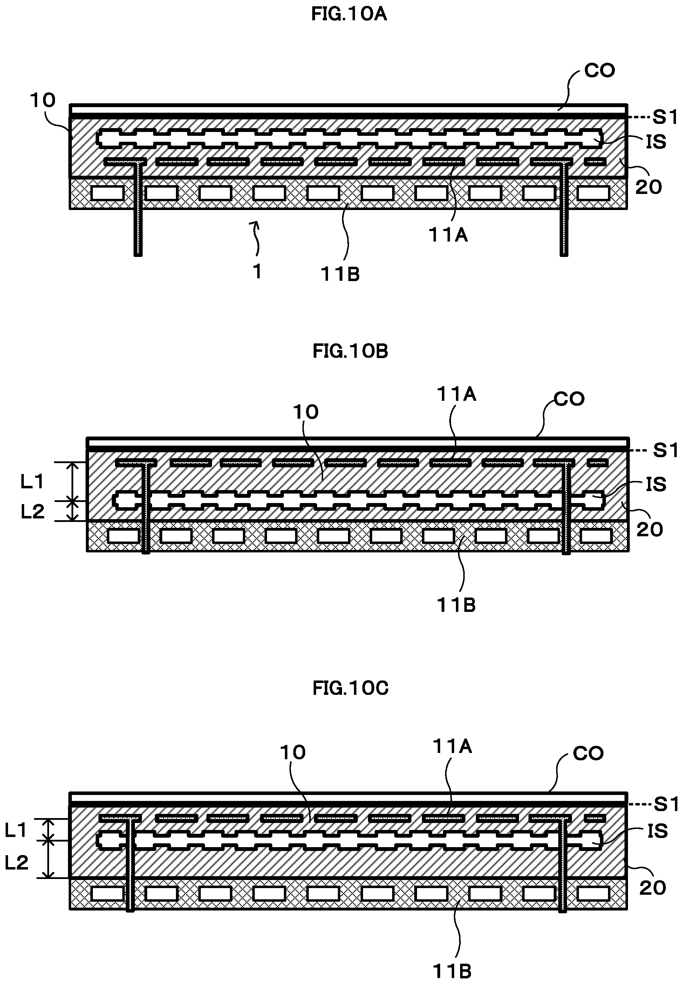

FIGS. 10A to 10C illustrate modified examples of arrangement of the heat diffusion plate 10 and the heat sources 11A and 11B. In the configuration illustrated in FIG. 10A, the heat source 11A is incorporated in the housing 20 of the heat diffusion plate 10, and the heat source 11B is attached to the surface opposite to the first surface S1 of the heat diffusion plate 10. The stacking order of the heat diffusion plate 10 and the heat sources 11A and 11B is the same as in the temperature control device 1 according to Embodiment 1 described above.

In the temperature control device 1 according to the above-described embodiment, the area of a portion of the heat sources 11A and 11B facing the heat diffusion plate 10 is smaller than the area of the first surface S1. In contrast, in the configuration illustrated in FIG. 10A, the area of a portion of the heat source 11A facing the heat diffusion plate 10 is the same as the area of the first surface S1. A configuration in which the area of the portion of the heat sources 11A and 11B facing the heat diffusion plate 10 is equal to or smaller than the area of the first surface S1 is advantageous for heat equalization in the controlled object CO.

The configurations illustrated in FIGS. 10B and 10C include the heat source 11A serving as a first heat source disposed on the surface opposite to the first surface S1 with the internal space IS interposed therebetween, and the heat source 11B serving as a second heat source disposed between the first surface S1 and the internal space IS. In the configuration illustrated in FIG. 10B, a distance L1 between the heat source 11A and the internal space IS is greater than or equal to a distance L2 between the heat source 11B and the internal space IS. Meanwhile, in the configuration illustrated in FIG. 10C, the distance L1 between the heat source 11A and the internal space IS is less than or equal to the distance L2 between the heat source 11B and the internal space IS. In this manner, adjusting the balance between the distances L1 and L2 as appropriate enables optimization of thermal conditions of the heat diffusion plate 10 in accordance with conditions such as a heater temperature, a boiling point of the working fluid 21, and heat conductivity of the housing 20.

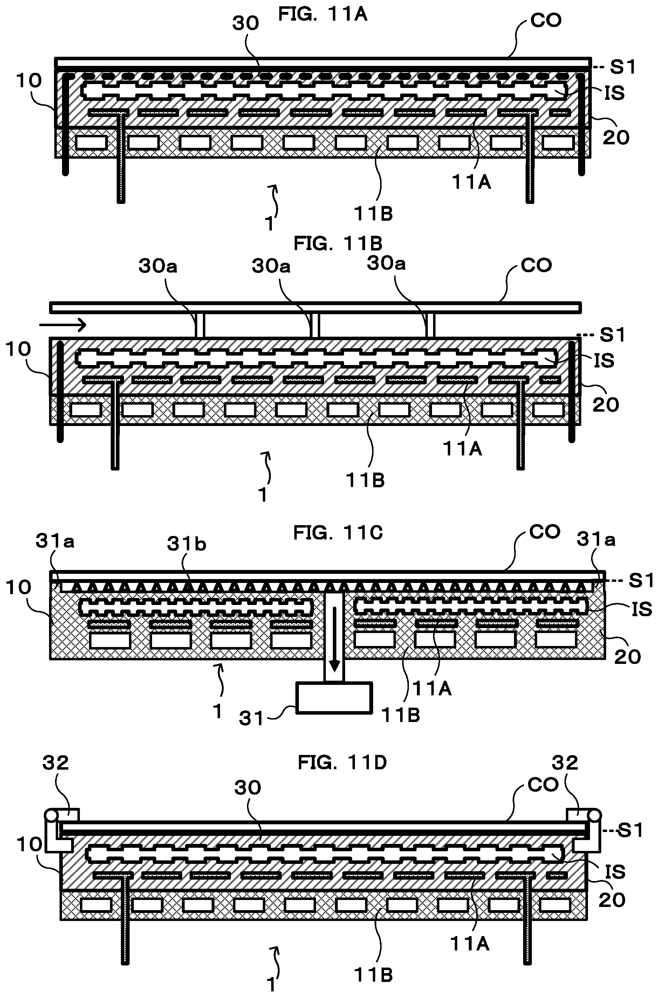

As illustrated in FIGS. 11A to 11C, the temperature control device 1 may include a holding mechanism that absorbs and holds the controlled object CO. As illustrated in FIG. 11A, the temperature control device 1 may include, as the holding mechanism, an electrostatic adsorption mechanism 30 that electrostatically adsorbs the controlled object CO. This configuration can maintain the in-plane variation in the temperature T of the controlled object CO within the permissible value while holding the controlled object CO.

As illustrated in FIG. 11B, the temperature control device 1 may include a holding mechanism that includes a plurality of pins 30a capable of protruding from the first surface S1 and holds the controlled object CO by, for example, electrostatic absorption with the plurality of pins 30a. This provides a gap between the control object CO and the first surface S1. The holding mechanism may include a gas supply mechanism that fills the gap with gas. A configuration in which a gap is provided between the controlled object CO and the first surface S1 and gas flows through the gap can reduce the overall heat transfer coefficient h between the heat diffusion plate 10 and the controlled object CO. As a result, the Biot number Biᵣ can be reduced to achieve further heat equalization in the controlled object CO.

As illustrated in FIG. 11C, the temperature control device 1 may include, as the holding mechanism, a vacuum adsorption mechanism 31 that vacuum-adsorbs the controlled object CO. The vacuum absorption mechanism 31 supports the controlled object CO with a rim 31a around its periphery and a large number of pins 31b in its inner region. The controlled object CO and the temperature control device 1 evacuate the gap formed therebetween to vacuum-adsorb the controlled object CO. This configuration can reduce the overall heat transfer coefficient h between the heat diffusion plate 10 and the controlled object CO. As a result, the Biot number Biᵣ can be reduced to achieve further heat equalization in the controlled object CO.

As illustrated in FIG. 11D, the temperature control device 1 may include, as the holding mechanism, a clamp mechanism 32 that holds the controlled object CO with a clamp. The clamp mechanism 32 is fixed to the housing 20 and retains a peripheral portion of the controlled object CO with its movable portion. This can suppress warpage of the controlled object CO.

The temperature control device 1 can be applied to control of the controlled object CO in a manufacturing process to manufacture a product. For example, the controlled object CO can be a wafer W in a semiconductor manufacturing process. The temperature control device 1 can maintain variation in the in-plane temperature T of the wafer W within a permissible value in substrate processing performed on the wafer W, such as exposure processing, development processing, etching processing, or the like.

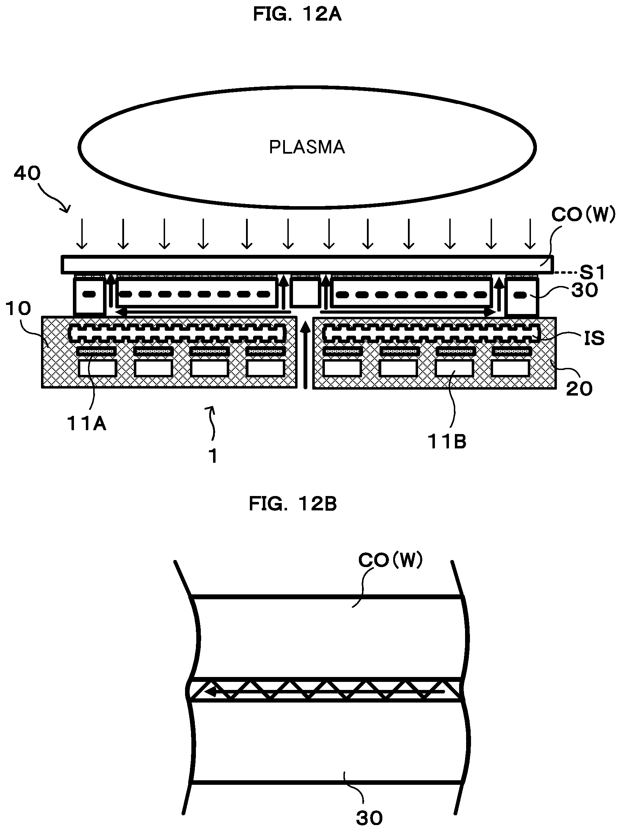

FIGS. 12A and 12B illustrate a configuration of a dry etching device 40 that performs dry etching on the wafer W. As illustrated in FIG. 12A, the dry etching device 40 incorporates the temperature control device 1. The temperature control device 1 includes the heat diffusion plate 10, the plurality of heat sources 11A and 11B, and the electrostatic adsorption mechanism 30 serving as a holding mechanism of the wafer W. Plasma for performing dry etching from above is supplied onto the wafer W. Heat from the plasma is transferred to the wafer W as well as to the heat diffusion plate 10. In the heat diffusion plate 10, the heat from the plasma is diffused to achieve heat equalization in the wafer W. In other words, herein, a supply source for supplying plasma as a fluid also functions as a heat source that performs heat transfer with the heat diffusion plate 10.

As illustrated in FIG. 12B, unevenness of a surface of the electrostatic adsorption mechanism 30 results in a gap between the electrostatic adsorption mechanism 30 and the wafer W. The electrostatic adsorption mechanism 30 supplies helium to the gap. As a result, heat generated between the electrostatic adsorption mechanism 30 and the wafer W is either transferred in a portion where the electrostatic adsorption mechanism 30 and the wafer W are in contact or transferred by motion of helium particles moving across the gap. Helium is lighter than air or etching gas and has a faster molecular motion velocity. This can improve the efficiency of heat transfer between the electrostatic adsorption mechanism 30 and the wafer W. The helium also serves as a heat source (cooling source) in the temperature control device 1.

A temperature range of the wafer W in the dry etching device 40 widely ranges from a high temperature of nearly 250°C to an extremely low temperature of -70°C. Therefore, a solvent optimized for each desired temperature is required as a coolant of the heat source 11B.

Plasma is used not only in the dry etching device 40, but also in a device that performs chemical vapor deposition (CVD) or in a device that performs atomic layer deposition (ALD). Therefore, in this type of substrate processing device as well, the temperature control device 1 can employ a plasma supply source as one of the heat sources.

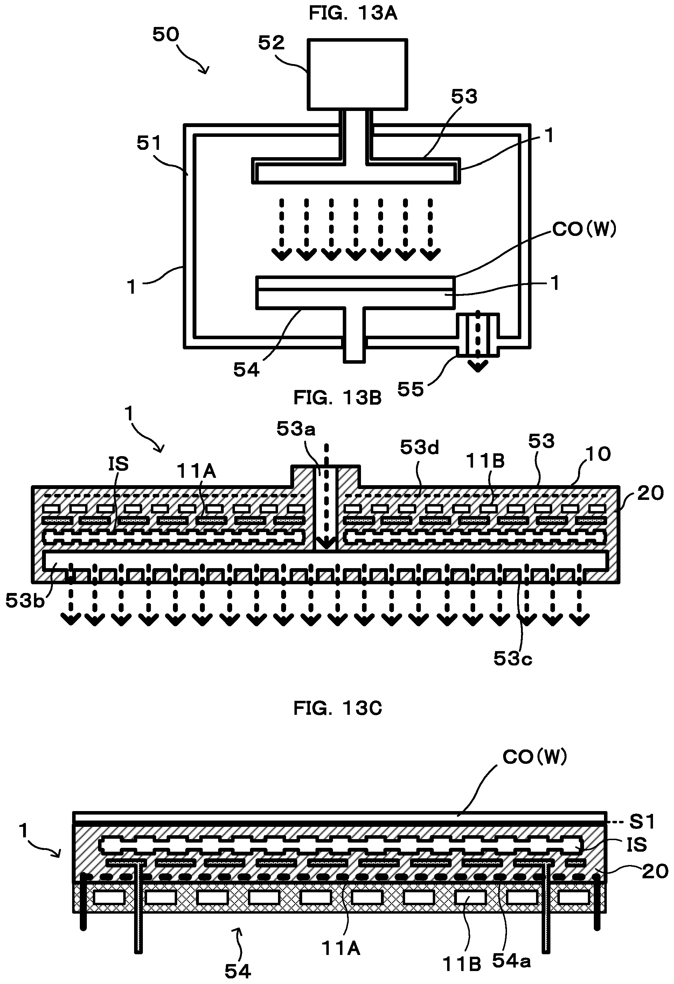

FIG. 13A illustrates an overall configuration of a plasma treatment device 50. As illustrated in FIG. 13A, the plasma treatment device 50 includes a chamber 51, a gas supply source 52, a shower head 53, a substrate holder 54, and an outlet 55. The chamber 51 is a housing of the plasma treatment device 50. The gas supply source 52 supplies process gas into the chamber 51. The shower head 53 diffuses and outputs the gas supplied from the gas supply source 52 over a wide region in the chamber 51. The substrate holder 54 holds the wafer W. The outlet 55 discharges the gas in the chamber 51.

As illustrated in FIG. 13B, the shower head 53 has a gas supply channel 53a, a gas reservoir 53b, a plurality of gas inlets 53c, and an upper radio frequency (RF) electrode pattern 53d. The process gas supplied from the gas supply source 52 is transferred from the gas supply channel 53a to the gas reservoir 53b, and spreads laterally in the gas reservoir 53b. The plurality of gas inlets 53c are provided on a lower surface of the gas reservoir 53b, and gas is discharged into the chamber 51 through the gas inlets 53c. The upper RF electrode pattern 53d is an electrode to which voltage is applied to generate plasma in gas. In the shower head 53 illustrated in FIG. 13B, the upper RF electrode pattern 53d is disposed farther from the gas reservoir 53b than the heat sources 11A and 11B, but is not limited thereto. The upper RF electrode pattern 53d may be disposed closer to the gas reservoir 53b than the heat sources 11A and 11B, or may be disposed between the heat sources 11A and 11B.

The shower head 53 incorporates the temperature control device 1 that includes the heat diffusion plate 10 and the heat sources 11A and 11B. The temperature control device 1 equalizes heat of the process gas filled in the gas reservoir 53b. As a result, the gas with the equalized heat is discharged into the chamber 51, and the wafer W can be processed with the gas with less temperature unevenness.

As illustrated in FIG. 13C, the substrate holder 54 incorporates the temperature control device 1 that includes the heat diffusion plate 10 and the heat sources 11A and 11B. The temperature control system 1 can diffuse heat transferred from the heat sources 11A and 11B and the process gas in the chamber 51 to achieve heat equalization in the wafer W. The substrate holder 54 includes a lower RF electrode pattern 54a. A high voltage is applied between the upper RF electrode pattern 53d and the lower RF electrode pattern 54a to generate plasma.

As illustrated in FIG. 13A, the chamber 51 incorporates the temperature control device 1 that includes the heat diffusion plate 10 and the heat sources 11A and 11B. This configuration can reduce temperature unevenness of the process gas discharged from the shower head 53, and achieve heat equalization in the process gas in the chamber 51. In this case, the temperature control device 1 is not limited to a flat plate shape, and may be formed to have a surface shape curved relative to a plane. Herein, the flat plate-shaped temperature control device 1 may be disposed to cover an inner wall of the chamber 51.

The configurations illustrated in FIGS. 13A, 13B, and 13C can be employed as a configuration of a liquid processing device that performs liquid processing on the wafer W. For example, the configurations illustrated in FIGS. 13A, 13B, and 13C can be employed as a configuration of a device that performs a cleaning process or a reaction process, such as wet etching, on the wafer W using a cleaning or processing solution. In this case, the upper RF electrode pattern 53d and the lower RF electrode pattern 54a can be omitted.

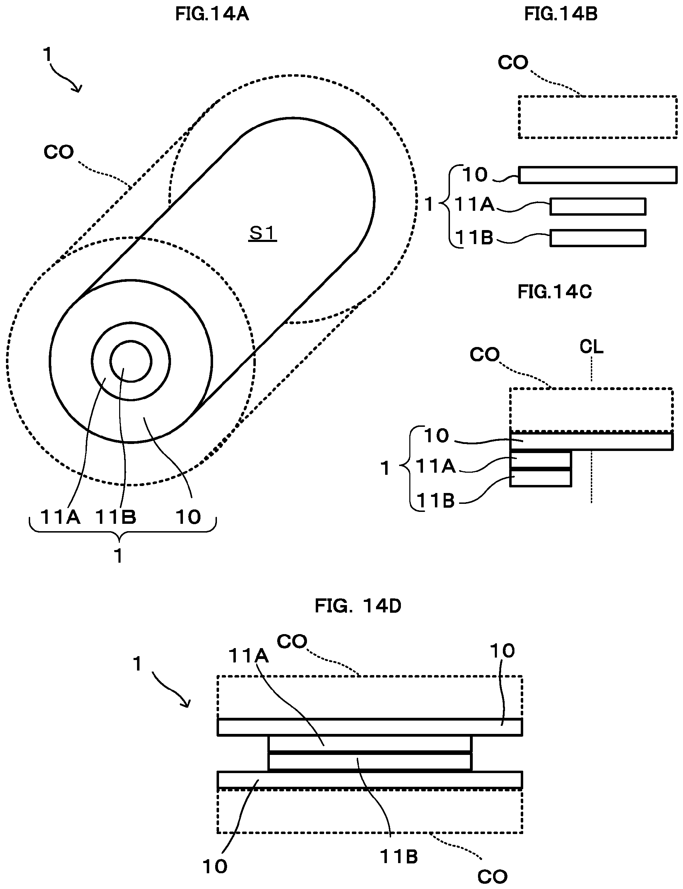

The temperature control device 1 according to the above-described embodiment has a disk shape, but is not limited thereto. The temperature control device 1 may have, for example, a polygonal flat plate shape. Further, as described above, the temperature control device 1 is not limited to a planar shape. For example, as illustrated in FIG. 14A, the temperature control device 1 may have a columnar shape or the like. In this case, the heat sources 11A and 11B have a columnar shape, the heat source 11B is formed from its central axis to its periphery to be in contact with a side surface of the heat source 11A, and the cylindrical heat diffusion plate 10 is formed to be in contact with a side surface of the heat source 11B. In this case, a side surface of the heat diffusion plate 10, as the first surface S1, faces the controlled object CO. In this manner, the first surface S1 may have a surface shape curved relative to a plane. The surface shape of the first surface S1 may be a sphere surface shape or other curved surface shapes.

As illustrated in FIG. 14B, the heat sources 11A and 11B may be disposed away from the heat diffusion plate 10. A distance δ between the heat sources 11A and 11B and the heat diffusion plate 10 can be used to change heat resistance therebetween (δ/(kA); k is heat conductivity therebetween and A is a heat transfer area). The same also applies between the heat diffusion plate 10 and the controlled object CO.

As illustrated in FIG. 14C, the heat sources 11A and 11B may be disposed with an offset from a center CL of the heat diffusion plate 10.

As illustrated in FIG. 14D, the heat diffusion plates 10 may be disposed on both sides of the heat sources 11A and 11B. This configuration enables, when the controlled objects CO are disposed on both side, heat equalization in the controlled objects CO on both sides.

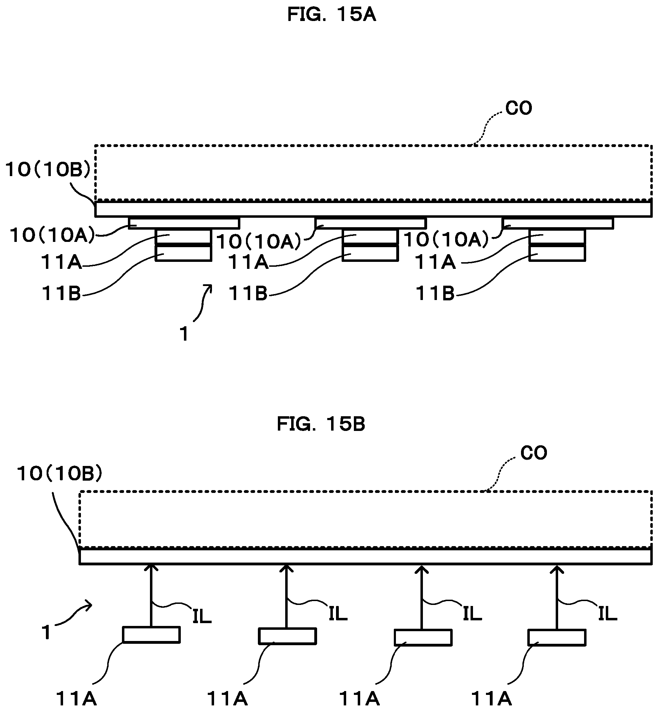

As illustrated in FIG. 15A, when the area of the controlled object CO is large, a plurality of devices each including the heat diffusion plate 10 (10A) and the heat sources 11A and 11B may be connected to the heat diffusion plate 10 (10B) with a larger area of the first surface S1. In this manner, stacking the heat diffusion plates 10 enables heat equalization in the controlled object CO with a large area. As described above, the temperature control device 1 may include a plurality of stacked sets each including the heat diffusion plate 10 and the plurality of heat sources 11A.

As illustrated in FIG. 15B, the plurality of heat sources 11A that irradiate laser light IL may be disposed facing the heat diffusion plate 10 (10B). In this configuration as well, stacking the heat diffusion plates 10 enables heat equalization in the controlled object CO with a large area.

As described above, the temperature control device 1 according to the present embodiment is suitable for heat equalization in the controlled object CO with a large area. Generally, in heat equalization in the controlled object CO with a large area, the temperature control device 1 may include the plurality of heat diffusion plates 10 (10A and 10B) stacked in a normal direction of the first surface S1.

There are no particular restrictions on the size of the first surface S1. The size of the first surface S1 in the temperature control device 1 can be determined based on the area of the controlled object CO and the permissible value of temperature unevenness. When one temperature control device 1 cannot maintain temperature unevenness within the permissible value, a configuration may be provided in which the controlled object CO is divided into a plurality of regions and the temperature control devices 1 are disposed in the respective divided regions. However, the temperature control device 1 according to the above-described embodiment can reduce the Biot number Biᵣ and increase the temperature diffusion coefficient α. This can reduce the number of the divided regions required to achieve an equivalent level of heat equalization compared to conventional systems.

In the temperature control device 1, the heat source 11A in contact with the heat diffusion plate 10 serves as the heating source, and the heat source 11B in contact with the heat source 11A serves as the cooling source. However, a configuration may be provided in which the heat source 11A serves as the cooling source and the heat source 11B serves as the heating source. The temperature control device 1 may include three or more heat sources. In this case, with reference to the heat diffusion plate 10, a heating source, a cooling source, and a heating source may be stacked in this order, or may be stacked in a different order. In a configuration including a plurality of heating sources and a plurality of cooling sources, overshoot and undershoot can be further suppressed by increasing the number of heating sources that perform heating simultaneously or by increasing the number of cooling sources that perform cooling simultaneously. In any case, it is necessary to provide at least one heating source and at least one cooling source.

The foregoing describes some example embodiments for explanatory purposes. Although the foregoing discussion has presented specific embodiments, persons skilled in the art will recognize that changes may be made in form and detail without departing from the broader spirit and scope of the invention. Accordingly, the specification and drawings are to be regarded in an illustrative rather than a restrictive sense. This detailed description, therefore, is not to be taken in a limiting sense, and the scope of the invention is defined only by the included claims, along with the full range of equivalents to which such claims are entitled.

This application claims the priority of Japanese Patent Application No. 2023-179687, filed on October 18, 2023, the entire disclosure of which is incorporated by reference herein.

### Industrial Applicability

The present disclosure can be applied to achieve temperature equalization in a controlled object.

### Reference Signs List

- 1: Temperature control device
- 10, 10A, 10B: Heat diffusion plate
- 11A, 11B: Heat source
- 11Aa: Heat transfer wire
- 11a: Region
- 11Ba: Cooling water flow path
- 12: Temperature sensor
- 13: Controller
- 20: Housing
- 21: Working fluid
- 30: Electrostatic adsorption mechanism
- 30a: Pin
- 31: Vacuum absorption mechanism
- 31a: Rim
- 31b: Pin
- 32: Clamp mechanism
- 40: Dry etching device
- 50: Plasma treatment device
- 51: Chamber
- 52: Gas supply source
- 53: Shower head
- 53a: Gas supply channel
- 53b: Gas reservoir
- 53c: Gas inlet
- 53d: Upper RF electrode pattern
- 54: Substrate holder
- 54a: Lower RF electrode pattern
- 55: Outlet
- 60: CPU
- 61: Memory
- 62: External storage device
- 63: Operator
- 64: Display
- 65: Internal bus
- 100: Information processing device
- CO: Controlled object
- IS: Internal space
- S1: First surface (facing surface)
- S2: Second surface
- IL: Laser light
- HW: Computer

## Claims

1. A temperature control device comprising:
a heat diffusion plate being a member including a facing surface facing a controlled object, the heat diffusion plate being configured to equalize heat in a surface direction of the facing surface; and
a plurality of heat sources to perform heat transfer with the heat diffusion plate, wherein
the heat diffusion plate includes
a housing having a sealed internal space and being made of a material containing one of ceramics, a ceramic composite material, or an inorganic substance except for metal, and
a working fluid enclosed in the internal space, the working fluid being configured to circulate in the internal space along the surface direction of the facing surface while repeating vaporization by heat reception and condensation by heat radiation, and
the heat diffusion plate has a smaller Biot number than a solid plate having same shape, size, and material as the heat diffusion plate, and has a larger temperature diffusion coefficient than the solid plate having same shape, size, and material as the heat diffusion plate, in such a way that a heat equalization time from start of heating or heat-absorbing in the heat diffusion plate to completion of temperature equalization on the facing surface is shorter than a heat equalization time for the solid plate having same shape, size, and material as the heat diffusion plate.

2. The temperature control device according to claim 1, further comprising:
as the plurality of heat sources, a heating source to heat the heat diffusion plate and a cooling source to cool the heat diffusion plate;
a temperature sensor to detect a temperature distribution of the controlled object; and
a controller to independently control the heating source and the cooling source based on a deviation between a temperature of the controlled object and a target temperature in such a way as to shorten the heat equalization time for the controlled object following the target temperature.

3. The temperature control device according to claim 2, wherein
the heating source is configured as an electrode heater.

4. The temperature control device according to claim 2, wherein
the heating source includes one of a high-frequency heater to irradiate a high-frequency electromagnetic wave to heat the working fluid, an induction heater to induce an eddy current in a conductor mounted on the housing to heat the housing, or a light source to irradiate laser light or light to heat the housing, or a combination thereof with an electrode heater.

5. The temperature control device according to claim 2, wherein
the heating source includes one of a supply source to supply plasma for heat transfer to the controlled object, a supply source to supply gas for heat transfer to the controlled object, or a supply source to supply liquid for heat transfer to the controlled object, or a combination thereof with an electrode heater.

6. The temperature control device according to any one of claims 2 to 5, wherein
the cooling source includes one of a flow path structure through which a cooling water flows, a fin, a Peltier element, a cold plate, a cooling element connected to a heat exchanger, a cooling element integrated with a heat exchanger, a supply source to supply gas for heat transfer to the controlled object, or a supply source to supply liquid for heat transfer to the controlled object, or a combination thereof.

7. The temperature control device according to any one of claims 1 to 6, wherein
at least one of the plurality of heat sources is mounted on an outer surface parallel to the facing surface in the housing.

8. The temperature control device according to any one of claims 1 to 7, wherein
at least one of the plurality of heat sources is mounted in the housing.

9. The temperature control device according to claim 8, wherein
the housing includes a partition dividing the internal space into two spaces in a direction intersecting the facing surface, and
at least one of the plurality of heat sources is mounted on the partition in the housing.

10. The temperature control device according to any one of claims 1 to 9, wherein
at least one of the plurality of heat sources is formed separately from the housing.

11. The temperature control device according to claim 10, wherein
the at least one heat source formed separately from the housing may be installed in the housing via a thermal interface material.

12. The temperature control device according to any one of claims 1 to 11, wherein
at least one of the plurality of heat sources is disposed on a surface opposite to the facing surface with the internal space interposed therebetween.

13. The temperature control device according to any one of claims 1 to 12, wherein
at least one of the plurality of heat sources is disposed between the facing surface and the internal space.

14. The temperature control device according to any one of claims 1 to 13, further comprising:
as the plurality of heat sources, a first heat source disposed on a surface opposite to the facing surface with the internal space interposed therebetween, and a second heat source disposed between the facing surface and the internal space, wherein
a distance between the first heat source and the internal space is greater than or equal to a distance between the second heat source and the internal space.

15. The temperature control device according to any one of claims 1 to 13, further comprising:
as the plurality of heat sources, a first heat source disposed on a surface opposite to the facing surface with the internal space interposed therebetween, and a second heat source disposed between the facing surface and the internal space, wherein
a distance between the first heat source and the internal space is less than or equal to a distance between the second heat source and the internal space.

16. The temperature control device according to any one of claims 1 to 15, further comprising:
a holding mechanism to absorb and hold the controlled object, wherein
the holding mechanism is one of an electrostatic adsorption mechanism to electrostatically adsorb the controlled object, a vacuum absorption mechanism to vacuum-adsorb the controlled object, or a clamp mechanism to hold the controlled object with a clamp.

17. The temperature control device according to claim 16, wherein
the holding mechanism includes a plurality of pins protruding from the facing surface, and a gap is provided between the controlled object and the facing surface by holding the controlled object with the plurality of pins.

18. The temperature control device according to claim 17, wherein
the holding mechanism includes a gas supply mechanism to fill the gap with gas.

19. The temperature control device according to any one of claims 1 to 18, wherein
the housing is made of one of ceramics, a ceramic composite material, an inorganic substance except for metal, a composite resin of ceramics and a resin, or a composite resin of an inorganic substance and a resin.

20. The temperature control device according to any one of claims 1 to 19, wherein
an inner surface of the housing is made of a material not corroded by the working fluid.

21. The temperature control device according to any one of claims 1 to 20, wherein
the housing is in contact with the controlled object via a thermal interface material.

22. The temperature control device according to any one of claims 1 to 21, wherein
an area of a portion of the plurality of heat sources facing the heat diffusion plate is equal to or smaller than an area of the facing surface.

23. The temperature control device according to any one of claims 1 to 22, wherein
the facing surface has a surface shape curved relative to a plane.

24. The temperature control device according to any one of claims 1 to 23, wherein
a plurality of the heat diffusion plates are stacked in a normal direction of the facing surface.
